(19) **Europäisches Patentamt**

**European Patent Office**

**Office européen des brevets**

(11) **EP 1 586 167 B1**

(12) **EUROPÄISCHE PATENTSCHRIFT**

(45) Veröffentlichungstag und Bekanntmachung des Hinweises auf die Patenterteilung:
**13.12.2006 Patentblatt 2006/50**

(21) Anmeldenummer: **03767740.8**

(22) Anmeldetag: **04.12.2003**

(51) Int Cl.:
*H04B 1/28* (2006.01)     *H03D 7/16* (2006.01)

(86) Internationale Anmeldenummer:
**PCT/EP2003/013713**

(87) Internationale Veröffentlichungsnummer:
**WO 2004/066512 (05.08.2004 Gazette 2004/32)**

(54) **VORRICHTUNG UND VERFAHREN ZUM ABWÄRTSMISCHEN EINES EINGANGSSIGNALS IN EIN AUSGANGSSIGNAL**

SYSTEM AND METHOD FOR DOWNWARD MIXING AN INPUT SIGNAL INTO AN OUTPUT SIGNAL

DISPOSITIF ET PROCEDE PERMETTANT DE MELANGER ET D'ABAISSER UN SIGNAL D'ENTREE POUR OBTENIR UN SIGNAL DE SORTIE

(84) Benannte Vertragsstaaten:
**AT BE BG CH CY CZ DE DK EE ES FI FR GB GR HU IE IT LI LU MC NL PT RO SE SI SK TR**

(30) Priorität: **23.01.2003 DE 10302647**

(43) Veröffentlichungstag der Anmeldung:
**19.10.2005 Patentblatt 2005/42**

(73) Patentinhaber: **Fraunhofer-Gesellschaft zur Förderung der angewandten Forschung e.V.
80686 München (DE)**

(72) Erfinder:
• **JUNG, Peter
67697 Otterberg (DE)**
• **SAPPOK, Sören
52223 Stolberg (DE)**

(74) Vertreter: **Zinkler, Franz
Schoppe, Zimmermann, Stöckeler & Zinkler
Postfach 246
82043 Pullach bei München (DE)**

(56) Entgegenhaltungen:
**US-A- 4 642 675**

• **DER L ET AL: "A 2GHz CMOS image-reject receiver with sign-sign LMS calibration" IEEE INTERNATIONAL SOLID-STATE CIRCUITS CONFERENCE, 5. Februar 2001 (2001-02-05), Seiten 294-456, XP010536274**
• **BATEMAN A ET AL: "Linear transceiver architectures" IEEE, 15. Juni 1988 (1988-06-15), Seiten 478-484, XP010077586**
• **KONG-PANG PUN ET AL: "A digital method for the correction of I/Q phase errors in complex sub-sampling mixers" IEEE, 27. Februar 2000 (2000-02-27), Seiten 171-174, XP010376900**

**Beschreibung**

Die vorliegende Erfindung bezieht sich auf analoge oder digitale Übertragungstechniken und insbesondere auf Empfangsstrukturen zum Abwärtsmischen von Eingangssignalen.

Die rasche Verbreitung von modernen Übertragungstechnologien, die beispielsweise bei einer Mobilfunkübertragung eingesetzt werden, stellen einen Entwurf von Hochfrequenz-Empfängern (HF-Empfängern) vor große Herausforderungen. Zum einen wächst die Bedeutung von günstigen und effizienten Empfangsstrukturen, die vorzugsweise mit Hilfe von Digitaltechnik in den immer kleiner werdenden mobilen Empfangsteilen eingesetzt werden können. Aus diesem Grund ist es wichtig, daß die Empfangsstrukturen bzw. daß Teile der Empfangsstrukturen beispielsweise mit Hilfe der MOS-Technologien (MOS; MOS = metal oxid semiconductor) realisiert werden können. Zum anderen ist mit wachsenden Übertragungsraten von Bedeutung, Empfangsstrukturen einzusetzen, die derartige Übertragungssignale genügend genau beispielsweise von einem Frequenzbereich, dem eine Trägerfrequenz zugeordnet ist, in einen anderen Frequenzbereich, dem eine wählbare Zwischenfrequenz zugeordnet ist, umsetzt, damit die Daten möglichst genau demoduliert und detektiert werden, was insbesondere im Hinblick auf eine Erzielung von geringen Bitfehlerwahrscheinlichkeiten wünschenswert ist.

Mit einer wachsenden Verbreitung unterschiedlichster Mobilfunkstandards, wie beispielsweise dem GSM-Standard oder dem UMTS-Standard, ist es notwendig, daß die Empfangsstrukturen flexibel genug sind, so daß sie beispielsweise in einem Empfangsgerät zum Abwärtsmischen von Empfangssignalen, die verschiedenen Mobilfunkstandards zugeordnet sind, eingesetzt werden können. Hierzu werden Empfängerkonzepte benötigt, die möglichst viele Standards durch einen Einsatz von geeigneten HF-Empfängern ermöglicht. Für einen Entwurf derartiger Empfänger sind neben Kosten, Größe, Leistungsverbrauch auch Integrationslevel und eine möglichst rasche Erzielung einer Marktreife der jeweiligen Prototypen (timeto-market) von entscheidender Bedeutung.

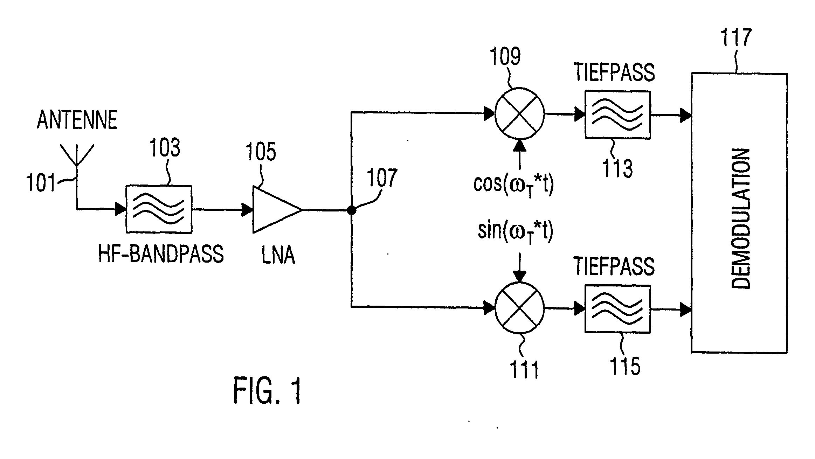

Der einfachste Ansatz zum Abwärtsmischen eines hochfrequenten Signals ist der Homodyn-Empfänger (Direktüberlagerungsempfänger, direct down receiver oder zero intermediate frequency receiver). In Fig. 1 ist ein prinzipieller Aufbau eines Homodyn-Empfängers dargestellt, wie er aus dem Stand der Technik bekannt ist.

Der in Fig. 1 dargestellte Empfänger umfaßt eine Empfangsantenne 101, ein Bandpaßfilter (HF-Bandpaß) 103, einen rauscharmen Verstärker 105 (LNA; LNA = low noise amplifier), einen Verzweigungspunkt 107, einen ersten Mischer 109, einen zweiten Mischer 111, wobei beide Mischer steuerbar sind, ein erstes Tiefpaßfilter 113, ein zweites Tiefpaßfilter 115 sowie einen Demodulator 117.

Das über die Antenne 101 empfangene Eingangssignal wird zunächst durch das Bandpaßfilter 103 gefiltert und dem LNA 105 zugeführt. Das bandpaßgefilterte und verstärkte Empfangssignal wird an dem Verzweigungspunkt 107 in ein erstes und in ein zweites Teilempfangssignal aufgeteilt. Das erste Teilempfangssignal wird dem Mischer 109 zugeführt, das zweite Teilempfangssignal wird dem Mischer 111 zugeführt. Der Mischer 109 wird mit einem ersten Ansteuersignal cos ($\omega_T$t) angesteuert, der zweite Mischer 111 wird mit einem zweiten Ansteuersignal sin ($\omega_T$t) angesteuert. $\omega_T$ bezeichnet dabei eine Trägerfrequenz, die dem empfangenen hochfrequenten Eingangssignal zugeordnet ist. Die beiden Mischer 109 und 111 bewirken somit eine Basisbandmischung des Empfangssignals. Die nach der Basisbandmischung entstandenen Quadraturkomponenten I und Q werden jeweils dem Tiefpaßfilter 113 und 115 zugeführt, um einen gewünschten Kanal zur anschließenden Demodulation durch den Demodulator 117 auszuwählen. Die Quadraturkomponenten werden dann dem Demodulator 117 zugeführt wo sie je nach verwendeter Modulationsform (beispielsweise einer Quadraturamplitudenmodulation) demoduliert werden, so daß anschließend eine Detektion der übertragenen Daten stattfinden kann.

Nachteilig an dem in Fig. 1 dargestellten Homodyn-Empfänger ist, daß die beiden Ansteuersignale, die für die Mischer 109 und 111 benötigt werden, durch einen Lokaloszillator erzeugt werden müssen, wobei der Lokaloszillator eine Oszillationsfrequenz aufweist, die gleich der Trägerfrequenz ist. Es erweist sich als schwierig, eine hochfrequente, abstimmbare Oszillatorfrequenz zu generieren. Diese muß nicht nur hochpräzise sein, sondern auch zwei um 90 Grad phasenverschobene Ausgangssignale erzeugen, um I/Q-modulierte Signale herunterzumischen. Eine geringfügige Abweichung (I/Q-Fehlanpassung) führt beispielsweise im Falle einer QAM-Modulation (QAM; QAM = Quadratur Amplituden Modulation) zu Verzerrungen einer Signalraumkonstellation, bei denen sowohl Amplituden- als auch Phasenungenauigkeiten auftreten. Dies führt zu einer erhöhten Bitfehlerwahrscheinlichkeit (BER; BER = bit error probality). Diese Fehlanpassung kann beispielsweise durch Amplituden- oder Phasenungenauigkeiten, die an dem jeweiligen Mischer 109 oder 111 entstehen, verursacht werden.

Ein weiterer Nachteil an dem in Fig. 1 dargestellten Homodyn-Empfänger ist, daß nach der Basisbandmischung Gleichspannungsanteile entstehen, die in dem Basisband als Störsignale erscheinen und die Nutzsignale stören. Diese Gleichspannungsanteile können zwar beispielsweise mit Hilfe eines Kondensators (AC-Kopplung) eliminiert werden, hierbei wird jedoch eine schmalbandige Filterung benötigt, die eine große Einschwingzeit benötigt, die beispielsweise bei einem TDD-Signal (TDD; TDD = time domain duplex) dazu führen, daß das Signal nicht rechtzeitig empfangen werden kann.

Ein weiterer Nachteil an dem in Fig. 1 dargestellten Homodyn-Empfänger ist ein Rauschen, das insbesondere an einem jeweiligen Ausgang des jeweiligen Mischers 109, 111 mehrfach verstärkt wird. Durch eine direkte Rauschtransformation in das Basisband dominiert in diesem niederfrequenten Bereich das 1/f Rauschen einen gesamten Rauschpegel. Wird ein Homodynempfänger, wie er in Fig. 1 dargestellt ist, mit Hilfe der MOS-Technologie hergestellt, so wirkt sich insbesondere bei einem Einsatz von MOS-Transistoren das 1/f Rauschen stark aus, was einem Einsatz von beispielsweise einer CMOS-Technologie zur Herstellung des Homodyn-Mischers u.U. ausschließt.

Die Fehlanpassung kann beispielsweise durch Ungenauigkeiten bei der Ansteuerung des jeweiligen Mischers 109 oder 111 entstehen. Ist beispielsweise eine Phasendifferenz zwischen den beiden Ansteuersignalen, die in dem jeweiligen Mischer 109 und 111 zu einer Multiplikation mit dem jeweiligen Teilempfangssignal herangezogen werden, so sind die an den Eingängen des Demodulators 117 anliegenden Quadraturkomponenten nicht exakt um 90 Grad zueinander phasenverschoben, was zu einer Erhöhung der Bitfehlerwahrscheinlichkeit führt. Bei einer Abweichung der Oszillatorfrequenz von der Frequenz des Trägers wird das Signal ferner nicht exakt in das Basisband verschoben, so daß eine anschließende Demodulation erschwert wird, was zu einem Ansteigen der Bitfehlerwahrscheinlichkeit führt.

Darüber hinaus ist der Einsatz eines Homodyn-Empfängers, wie er in Fig. 1 dargestellt ist, problematisch, falls Empfangssignale abwärts gemischt werden sollen, denen jeweils eine unterschiedliche Trägerfrequenz zugeordnet ist, wie das beispielsweise bei einem GSM- oder auch UMTS-Empfangssignal der Fall ist, da der Lokaloszillator jeweils in einem weiten Frequenzbereich durchstimmbar sein müßte, was in der Praxis jedoch kostengünstig schwierig zu realisieren ist.

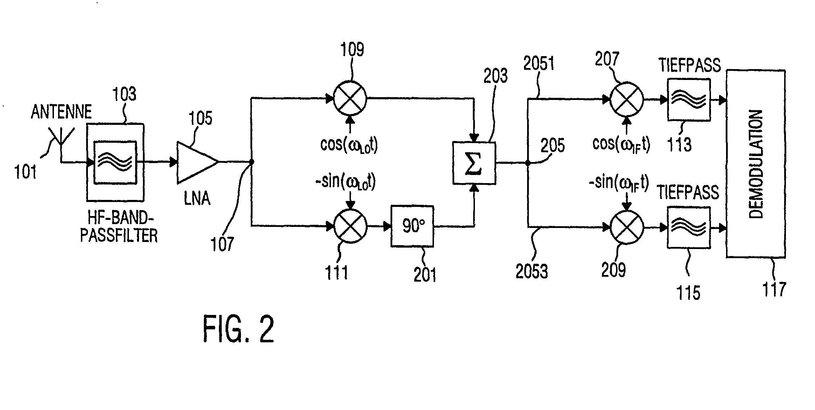

Aufgrund der beschriebenen Problematik können zur Abwärtsmischung von hochfrequenten Signalen Heterodyn-Empfänger eingesetzt werden. Fig. 2 zeigt einen Heterodyn-Empfänger, wie er aus dem Stand der Technik bekannt ist. Es handelt sich dabei um eine Empfangsstruktur, die unter dem Namen "Hartley Struktur" bekannt ist.

Im Unterschied zu dem in Fig. 1 dargestellten Homodynempfänger, werden bei dem in Fig. 2 dargestellten Heterodyn-Empfänger die beiden nach dem Verzweigungspunkt 107 entstehenden Teilempfangssignale den Mischern 109 und 111 zugeführt, die jeweils durch Ansteuersignale angesteuert werden, deren Schwingkreisfrequenz ($\omega_{LO}$) von der Trägerfrequenz des hochfrequenten Empfangssignals unterschiedlich ist. Darüber hinaus umfaßt der in Fig. 2 dargestellte Heterodyn-Empfänger einen Phasenschieber 201, dem ein am Ausgang des Mischers 111 anliegende Signal zugeführt wird. Die Ausgangssignale des Mischers 109 und des Phasenschiebers 201 werden einem Summierer 203 zugeführt und ein Ausgangssignal des Summierers 203 wird an einem weiteren Verzweigungspunkt 205 verzweigt, so daß ein erstes 2051 und ein zweites 2053 Teilsignal entstehen. Das erste Teilsignal 2051 wird einem dritten Mischer 207, das zweite Teilempfangssignal 2053 wird einem vierten Mischer 209 zugeführt. Der dritte Mischer 207 wird dabei mit einem Ansteuersignal cos ($\omega_{IF}t$) angesteuert, der vierte Mischer 209 wird mit einem Ansteuersignal -sin ($\omega_{IF}t$) angesteuert. Die an den jeweiligen Ausgängen der Mischer 207 und 209 entstandenen Teilempfangssignale werden jeweils den Tiefpaßfiltern 113 und 115 zugeführt und anschließend in dem Demodulator 117 demoduliert.

Die beiden Teilkomponenten des Empfangssignals werden zunächst mit Hilfe des ersten Mischers 109 und des zweiten Mischers 111 auf eine geeignete Zwischenfrequenz umgesetzt, die von der Frequenz $\omega_{LO}$ der beiden Ansteuersignale abhängig ist. Beide Ansteuersignale werden mit Hilfe eines Lokaloszillators, dessen Kreisoszillatorfrequenz $\omega_{LO}$ ist, erzeugt werden. Da nun die Frequenz des Lokaloszillator-Signals nicht der Trägerfrequenz entspricht, entstehen an den Ausgängen der Mischer 109 und 111 Mischprodukte, die durch eine geeignete Filterung, die in Fig. 2 nicht eingezeichnet ist, unterdrückt werden. Darüber hinaus entstehen an den Ausgängen der Mischer 109 und 111 Signalanteile, die um die doppelte Zwischenfrequenz um eine Oszillatorfrequenz $f_{LO}$ auseinander liegen. Um einen Kanal auszuwählen, ist es notwendig, nur einen Signalanteil auszuwählen, was jedoch lediglich durch eine Filterung der ZF-Signale nicht möglich ist.

Um einen Kanal herauszufiltern, kann das Empfangssignal vor der Mischung auf die erste Zwischenfrequenz mit einem Spiegelfrequenzunterdrückungsfilter gefiltert werden, wie es aus dem Stand der Technik bekannt ist. Nachteilig an diesem Ansatz ist jedoch, daß derartige Filter nur schwer in MOS-Technologie zu fertigen sind, da sich eine Herstellung von Spulen mit einer ausreichenden Güte als schwierig erweist. Aus diesem Grund müssen solche Elemente diskret aufgebaut werden und können daher nicht auf einem Chip integriert werden. Dabei können als Filter beispielsweise SAW-Filter (SAW; SAW = surface acoustic wave), keramische oder dielektrische Filter eingesetzt werden. Anstatt Spiegelfrequenzunterdrückungsfilter einzusetzen, können die Spiegelfrequenzen unter Ausnutzung von trigonometrischen Theoremen unterdrückt werden, wie es in dem in Fig. 2 dargestellten Heterodyn-Empfänger der Fall ist. Dabei wird das Ausgangssignal des Mischers 111 mit Hilfe des Phasenschiebers 201 zusätzlich um 90 Grad phasenverschoben, so daß nach der Addition, die in dem Summierer 203 durchgeführt wird, die Spiegelfrequenzen unterdrückt werden können. Danach wird das erste Teilsignal 2051 und das zweite Teilsignal 2053 mit Hilfe der Mischer 207 und 209 auf eine zweite Zwischenfrequenz umgesetzt, die von der Kreisfrequenz $\omega_{IF}$ der Ansteuersignale abhängt. Nach der Tiefpaßfilterung durch die Tiefpässe 113 und 115 werden die Quadraturkomponenten demoduliert und die demodulierten Daten detektiert.

Zu einer Erzielung der benötigten 180 Grad Phasendifferenz zwischen den an dem Summierer 203 anliegenden Signalen kann auf den in Fig. 2 gezeigten Phasenschieber 201 verzichtet werden, wenn die Ausgangssignale der Mischer 109 und 111 mit Hilfe eines weiteren Mischerpaares zusätzlich auf eine andere Zwischenfrequenz umgesetzt werden.

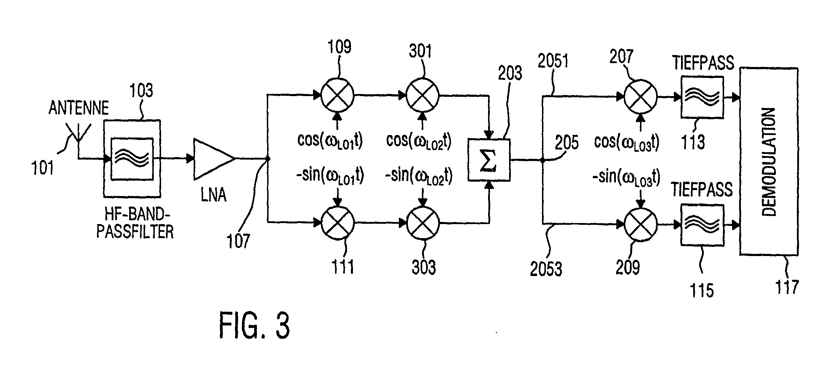

Fig. 3 zeigt einen prinzipiellen Aufbau eines Heterodyn-Receivers, wie er aus dem Stand der Technik bekannt ist. Es handelt sich hier um einen Spiegelfrequenzunterdrückungsempfänger, der unter dem Namen "Weaver Struktur" aus der Schrift von D. Verver: A third method of generation and detection of single sideband signals", Proc. IRE, Vol. 44, 1956, bekannt ist.

Die in Fig. 3 dargestellte Empfangsstruktur weist im Unterschied zu dem in Fig. 2 dargestellten Heterodyn-Empfänger einen fünften Mischer 301 und einen sechsten Mischer 303 auf. Die Mischer 109 und 111 werden jeweils mit einem Ansteuersignal cos $(\omega_{LO1}t)$ und -sin $(\omega_{LO1}t)$ angesteuert, so daß die jeweiligen Teilempfangssignale auf eine erste Zwischenfrequenz umgesetzt werden. Die umgesetzten Teilempfangssignale werden ferner durch den Mischer 301 und 303 auf eine zweite Zwischenfrequenz umgesetzt. Dazu werden die Mischer 301 und 303 jeweils mit einem Ansteuersignal cos $(\omega_{LO2}t)$ und -sin $(\omega_{LO2}t)$ angesteuert. Dadurch werden die Ausgangssignale der Mischer 109 und 111 nach einer eventuellen Filterung, die in Fig. 3 nicht eingezeichnet ist, auf die zweite Zwischenfrequenz umgesetzt. Aufgrund der dem Summierer 203 durchgeführten Summationen der Ausgangssignale der Mischer 301 und 303 werden nun Signalanteile bei einer Spiegelfrequenz im Idealfall unterdrückt, so daß an einem Ausgang des Summierers 203 ein Einseitenbandsignal entsteht.

Ein Nachteil an dem in Fig. 2 oder in Fig. 3 dargestellten Heterodyn-Empfänger besteht darin, daß bei einer Fehlanpassung zwischen der I-Komponente am Ausgang des Mischers 301 und der Q-Komponente am Ausgang des Mischers 303 eine geringe Spiegelsignaldämpfung erzielt wird. Schon eine geringe Phasen- oder auch Amplitudenabweichung zwischen den Signalen an den Ausgängen des Mischers 301 und 303, die beispielsweise durch herstellungsspezifische Bauteiltoleranzen entstehen kann, führt zu einer verringerten Spiegelfrequenzunterdrückung. Eine Phasen- oder Amplitudenabweichung kann beispielsweise dann entstehen, wenn die beiden Ansteuersignale, die die Mischer 109 und 111 ansteuern, nicht exakt 90 Grad phasenverschoben zueinander sind. Die gleiche Problematik taucht auf, wenn die beiden Ansteuersignale, die die Mischer 301 und 303 ansteuern, keine exakte Phasenverschiebung um 90 Grad aufweisen. Aufgrund einer analogen Bauweise der in Fig. 2 und Fig. 3 dargestellten Heterodyn-Empfänger kann die Fehlanpassung zwischen der I- und der Q-Komponente nicht ausgeschlossen werden.

Ein weiterer Nachteil an dem in Fig. 2 oder in Fig. 3 dargestellten Heterodyn-Empfänger ist, daß sie nicht flexibel genug sind, um hochfrequente Eingangssignale beispielsweise auf die erste Zwischenfrequenz umzusetzen, wenn den Eingangssignalen verschiedene Trägerfrequenzen zugeordnet sind, wie dies beispielsweise bei einem Multistandardempfang der Fall ist. Der Grund für diese Unflexibilität liegt darin, daß die jeweiligen Ansteuersignale analog mit Hilfe von Lokaloszillatoren erzeugt werden. Um beispielsweise verschiedene hochfrequente Empfangssignale, denen jeweils ein anderer Träger zugeordnet ist, auf die erste Zwischenfrequenz am Ausgang der Mischer 109 und 111 umzusetzen, ist es notwendig, daß ein Lokaloszillator, der die beiden Ansteuersignale für die Mischer 109 und 111 erzeugt, in einem weiten Frequenzbereich genügend genau durchstimmbar ist. Sind die beiden an den Ausgängen der Mischer 109 und 111 entstehenden Signale aufgrund der nicht exakten 90 Grad-Verschiebung zwischen den beiden Ansteuersignalen fehlangepaßt, so pflanzt sich diese Fehlanpassung fort, da aufgrund einer analogen Umsetzung durch die Mischer 301 und 303 die Phase der entstehenden I- und Q-Komponente nicht korrigiert werden kann.

Ein weiterer Nachteil der in Fig. 2 und in Fig. 3 dargestellten Heterodyn-Empfänger gemäß dem Stand der Technik besteht darin, daß sie aufgrund der eingesetzten analogen Bauteile teuer und schwer zu integrieren sind. Darüber hinaus ist mit den eingesetzten analogen Mischern 109, 111, 301, 303, 207 und 209 keine exakte Multiplikation möglich, so daß eine exakte Zwischenfrequenzumsetzung der jeweiligen Signale nicht erzielt werden kann, was zu einer Steigerung der Bitfehlerwahrscheinlichkeit führt. Darüber hinaus werden an den Nicht-Linearitäten der analogen Bauelemente ferner Intermodulationsfrequenzen erzeugt, die sich störend auswirken zu einer weiteren Erhöhung der Bitfehlerwahrscheinlichkeit führen. Darüber hinaus hat eine geringe Abweichung der Teilempfangssignale, die an den Eingängen des Summierers 203 anliegen, in Bezug auf die Phase oder auf die Amplitude eine wesentliche Auswirkung auf die Spiegelfrequenzunterdrückung, was zu einem weiteren Anstieg der Bitfehlerwahrscheinlichkeit führt. Aus diesem Grund ist man gezwungen, die Pfade, über die die beiden Teilempfangssignale übertragen werden, möglichst symmetrisch bezüglich einer Dämpfung auszuführen, sowie möglichst stabile Oszillatoren zur Erzeugung der jeweiligen Ansteuersignale für die Mischer zu verwenden, was zu einer signifikanten Verteuerung von derartigen Heterodyn-Strukturen führt. Aufgrund einer analogen Ausführung aller eingesetzten Mischer ist es notwendig, die Mischer im Bezug auf ihr Rauschverhalten zu optimieren. Dies ist jedoch sehr aufwendig, da die Anforderungen an die Mischer aufgrund eines breitbandigen Arbeitsbereichs ansteigen, falls die Empfangsstrukturen zum Abwärtsmischen von Empfangssignalen eingesetzt werden, die jeweils unterschiedliche Trägerfrequenzen aufweisen.

Das US-Patent Nr. 4,642,675 A offenbart einen Superheterodyn-Empfänger mit einem ersten RF-Mischer und einem zweiten RF-Mischer, die ein hochfrequentes Eingangssignal auf ein Zwischenfrequenzsignal mit einer I- und Q-Komponente heruntersetzen. Ein RF-Oszillator und ein steuerbarer 90-Grad Phasenschieber werden verwendet, um die beiden RF-Mischer anzusteuern. Der Empfänger umfasst ferner zwei Limiter zum Beseitigen einer Modulation der I- und Q-Signale nach deren Filterung und Verstärkung. Die Ausgangssignale der Limiter werden einem Phasenvergleicher zugeführt, der den steuerbaren Phasenschieber so ansteuert, dass die Zwischenfrequenz I- und Q-Signale exakt 90 Grad zueinander phasenverschoben sind. Der Empfänger umfasst ferner zwei Demodulatoren zum Demodulieren der I- und Q-Signale. Die Ausgangssignale der Demodulatoren werden einem Addierer zugeführt, aus dessen Ausgangssignal nach einer Filterung ein Burst erzeugt wird. Der Burst synchronisiert einen Oszillator, dessen Ausgangssignal nach einer Frequenzteilung durch einen Phasen- und Frequenzvergleicher zugeführt wird. Der Phasen- und Frequenzvergleicher empfängt ein Ausgangssignal des ersten Limiters und liefert eine Steuerspannung, deren Polarität abhängig von einer Richtung einer Verstimmung ist, wenn die Eingangssignale größere Frequenzdifferenzen überschreiten. Die Steuerspannung wird dem RF-Oszillator zugeführt. Das Ausgangssignal des Oszillators steuert nach der Frequenzteilung den ersten Demodulator und nach einer 90 Grad Phasenschiebung, zu deren Erzeugung ein 90 Grad Phasenschieber verwendet wird, den zweiten Demodulator.

Die Aufgabe der vorliegenden Erfindung besteht darin, ein effizientes Konzept zum Abwärtsmischen von Empfangssignalen zu schaffen.

Diese Aufgabe wird durch eine Vorrichtung zum Abwärtsmischen eines Eingangssignals gemäß Patentanspruch 1 oder durch ein Verfahren zum Abwärtsmischen eines Eingangssignals gemäß Anspruch 17 gelöst.

Die erfindungsgemäße Vorrichtung zum Abwärtsmischen eines Eingangssignals in ein Ausgangssignal weist eine Einrichtung zum Erzeugen eines ersten Eingangssignals und eines zweiten Eingangssignals auf einer ersten Zwischenfrequenz auf, wobei die Einrichtung zum Erzeugen ausgebildet ist, um das erste Empfangssignal und das zweite Empfangssignal mit einer vorbestimmten ersten Phasenbeziehung zueinander zu erzeugen, eine Wandlereinrichtung zum Analog-Digital-Wandeln des ersten Empfangssignals auf der ersten Zwischenfrequenz, um eine digitale Darstellung des ersten Empfangssignals zu erhalten, und zum Analog-Digital-Wandeln des zweiten Empfangssignals, um eine digitale Darstellung des zweiten Empfangssignals zu erhalten, eine Phasendetektionseinrichtung zum Erfassen eines Phasenunterschieds zwischen der digitalen Darstellung des ersten Empfangssignals und der digitalen Darstellung des zweiten Empfangssignals, eine erste Mischereinrichtung zum Umsetzen der digitalen Darstellung des ersten Empfangssignals auf eine zweite Zwischenfrequenz, eine zweite Mischereinrichtung zum Umsetzen der digitalen Darstellung des zweiten Empfangssignals auf die zweite Zwischenfrequenz, eine Mischeransteuerungseinrichtung zum Ansteuern der ersten Mischereinrichtung mit einem ersten Ansteuersignal, das eine erste Frequenz aufweist, und zum Ansteuern der zweiten Mischereinrichtung mit einem zweiten Ansteuersignal, das die zweite Frequenz aufweist, wobei das erste und das zweite Ansteuersignal eine vorbestimmte Phasendifferenz aufweisen, eine Summationseinrichtung zum Summieren der Ausgangssignale der ersten und der zweiten Mischereinrichtung, wobei die Phasendetektionseinrichtung ausgebildet ist, um die Einrichtung zum Erzeugen und/oder die Mischeransteuerungseinrichtung so anzusteuern, daß die Ausgangssignale der ersten und der zweiten Mischereinrichtung in einer vorbestimmten Phasenbeziehung zueinander sind, so daß eine Spiegelfrequenzunterdrückung stattfindet.

Der vorliegenden Erfindung liegt die Erkenntnis zugrunde, daß eine genaue Spiegelfrequenzunterdrückung beim Abwärtsmischen erzielt werden kann, wenn Teile der Vorrichtung zum Abwärtsmischen digital ausgeführt werden.

Ein Vorteil der vorliegenden Erfindung ist darin zu sehen, daß die Spiegelfrequenzunterdrückung genau durchgeführt werden kann, da etwaige Phasen-, Frequenz- oder Amplitudenunterschiede zwischen dem ersten und dem zweiten Empfangssignal von der Phasendetektionseinrichtung digital erfaßt werden können, so daß Fehlanpassungen zwischen den etwaigen Signalen auf der ersten Zwischenfrequenz und/oder zwischen den etwaigen Signalen auf der zweiten Zwischenfrequenz korrigiert werden können.

Ein weiterer Vorteil der vorliegenden Erfindung liegt darin, daß die erfindungsgemäße Vorrichtung zum Abwärtsmischen im wesentlichen integrierbar ist, da die Performancebestimmenden Komponenten der erfindungsgemäßen Vorrichtung für eine Digitale Signalverarbeitung ausgeführt sind. Dies führt darüber hinaus zu einer Senkung der Herstellungskosten, des Leistungsverbrauchs sowie des Flächenverbrauchs.

Ein weiterer Vorteil der vorliegenden Erfindung ist darin zu sehen, daß eine Umsetzung der jeweiligen digitalen Darstellung des ersten und/oder zweiten Empfangssignals digital durchgeführt wird. So reduziert sich die Abwärtsmischung auf eine digitale Multiplikation, die mit Hilfe von effizienten digitalen Algorithmen kostengünstig realisiert werden kann. Zum Ansteuern der digitalen Mischereinrichtungen werden die jeweiligen Ansteuersignale digital erzeugt, so daß eine beliebige Frequenz und Phasenverschiebung zwischen den Ansteuersignalen genau realisiert werden kann, wobei hierzu weder Lokaloszillatoren noch Phasenschieber eingesetzt werden müssen. Zum einen werden dadurch die Herstellungskosten gesenkt, zum anderen wird eine genaue Umsetzung der jeweiligen Mischereingangssignale auf die zweite Zwischenfrequenz erzielt, so daß neben einer effizienten Spiegelfrequenzunterdrückung auch die Bitfehlerwahrscheinlichkeit bei der anschließenden Demodulation und Detektion gesenkt wird.

Ein weiterer Vorteil der vorliegenden Erfindung besteht darin, daß die Frequenz, die Phase und/oder die Amplitude der digitalen Darstellung des ersten und/oder des zweiten Empfangssignals mit einem geeignet gewählten Algorithmus, beispielsweise dem bereits erwähnten CORDIC-Algorithmus, berechnet werden kann. Dadurch können etwaige Phasen-, Frequenz- oder Amplitudenfehler genau und schnell berechnet sowie in einem weiteren Schritt kompensiert werden.

Ein weiterer Vorteil der vorliegenden Erfindung besteht darin, daß die erfindungsgemäße Vorrichtung zum Abwärtsmischen in einem Multistandard-Empfänger eingesetzt werden kann. Ein Multistandard-Empfänger zeichnet sich dadurch aus, daß er zum Empfangen von Empfangssignalen, denen jeweils eine unterschiedliche Trägerfrequenz zugeordnet werden kann, ausgebildet ist.

Bevorzugte Ausführungsbeispiele der vorliegenden Erfindung werden nachfolgend Bezug nehmend auf die beiliegenden Zeichnungen detailliert erläutert. Es zeigen:

Fig. 1 einen prinzipiellen Aufbau eines Homodyn-Empfängers;

Fig. 2 einen prinzipiellen Aufbau eines Heterodyn-Empfängers am Beispiel einer Hartley-Struktur;

Fig. 3 einen prinzipiellen Aufbau eines Heterodyn-Empfängers am Beispiel einer Weaver-Struktur;

Fig. 4 ein erstes Ausführungsbeispiel einer Vorrichtung zum Abwärtsmischen gemäß der vorliegenden Erfindung;

Fig. 5 ein weiteres Ausführungsbeispiel einer Vorrichtung zum Abwärtsmischen gemäß der vorliegenden Erfindung;

Fig. 6 ein weiteres Ausführungsbeispiel einer Vorrichtung zum Abwärtsmischen gemäß der vorliegenden Erfindung;

Fig. 7 ein weiteres Ausführungsbeispiel einer Vorrichtung zum Abwärtsmischen gemäß der vorliegenden Erfindung;

Fig. 8 ein Ausführungsbeispiel einer Frequenzausfalleinrichtung gemäß der vorliegenden Erfindung; und

Fig. 9 ein Simulationsergebnis eines Spiegelunterdrückungsverhältnisses (image reject ratio) bei einer Verwendung von analogen Empfangsstrukturen.

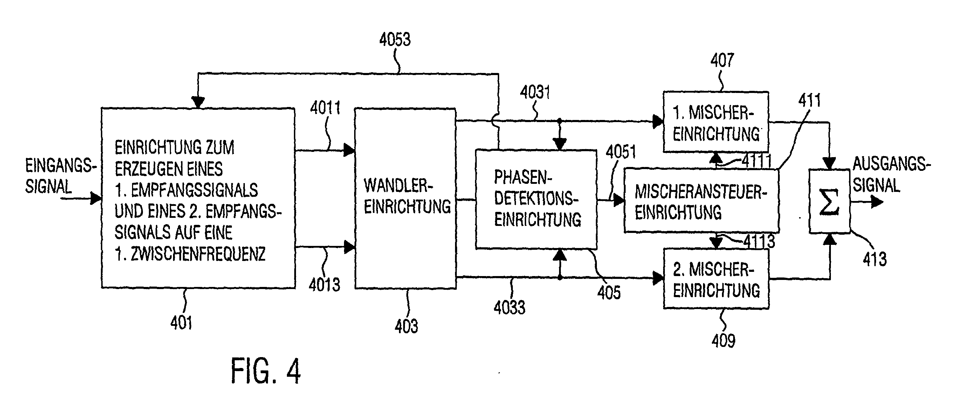

In Fig. 4 ist ein Ausführungsbeispiel der erfindungsgemäßen Vorrichtung zum Abwärtsmischen eines Eingangssignals dargestellt. Ein Eingangssignal wird einer Einrichtung 401 zum Erzeugen eines ersten Empfangssignals und 4011 und eines zweiten Empfangssignals 4013 auf einer ersten Zwischenfrequenz zugeführt. Das erste Empfangssignal 4011 und das zweite Empfangssignal 4013 werden von einer Wandlereinrichtung 403 empfangen. Die Wandlereinrichtung 403 liefert eine digitale Darstellung 4031 des ersten Empfangssignals 4011 und eine digitale Darstellung 4033 des zweiten Empfangssignals 4013.

Die digitale Darstellung 4031 des ersten Empfangssignals 4011 wird einer Phasendetektionseinrichtung 405 und einer ersten Mischereinrichtung 407 zugeführt. Die digitale Darstellung 4033 des zweiten Empfangssignals 4013 wird der Phasendetektionseinrichtung 405 und einer zweiten Mischereinrichtung 409 zugeführt. Das in Fig. 4 dargestellte Ausführungsbeispiel der erfindungsgemäßen Vorrichtung zum Abwärtsmischen umfaßt ferner eine Mischeransteuerungseinrichtung 411, die die erste Mischereinrichtung 407 mit einem ersten Ansteuersignal 4111 ansteuert, und die die zweite Mischereinrichtung 409 mit einem zweiten Ansteuersignal 4113 ansteuert. Ein Ausgangssignal der ersten Mischereinrichtung 407 und ein Ausgangssignal der zweiten Mischereinrichtung 409 werden einer Summationseinrichtung 413 zum Summieren der Ausgangssignale der ersten und der zweiten Mischereinrichtung zugeführt, wobei die Summationseinrichtung 413 ein Ausgangssignal liefert. Die Phasendetektionseinrichtung 405 liefert ferner ein erstes Signal 4051 zum Ansteuern der Mischeransteuereinrichtung 411 sowie ein zweites Signal 4053 zum Ansteuern der Einrichtung 401 zum Erzeugen.

Im folgenden wird die Funktionsweise des in Fig. 4 dargestellten Ausführungsbeispiels der erfindungsgemäßen Vorrichtung zum Abwärtsmischen erklärt.

Die Einrichtung 401 zum Erzeugen empfängt das Eingangssignal, das ein hochfrequentes Signal sein kann, und erzeugt auf der Basis des Eingangssignals das erste Empfangssignal 4011 und das zweite Empfangssignal 4011 auf der ersten Zwischenfrequenz. Dabei weisen das erste Empfangssignal 4011 und das zweite Empfangssignal eine vorbestimmte erste Phasenbeziehung zueinander auf. Zum Erzeugen des ersten und des zweiten Empfangssignals kann die Einrichtung 401 zum Erzeugen beispielsweise einen balanzierten Ringmodulator zum Erzeugen des ersten und des zweiten Empfangssignals auf der ersten Zwischenfrequenz ausgehend von dem Eingangssignal, dem eine Trägerfrequenz zugeordnet sein kann, aufweisen. Es ist jedoch durchaus denkbar, daß die Einrichtung 401 zum Erzeugen andere Einrichtungen aufweist, wie beispielsweise geeignet angesteuerte analoge Mischer, mit denen die beiden Empfangssignale 4011 und 4013 auf der ersten Zwischenfrequenz erzeugt werden können. Unterscheiden sich das erste Empfangssignal 4011 und das zweite Empfangssignal 4013 bei einer gleichen Frequenz um 90 Grad bezüglich einer Phase, so handelt es sich dabei um Quadratursignale, wobei das erste Empfangssignal 4011 beispielsweise eine I-Komponente und das zweite Empfangssignal 4013 eine Q-Komponente darstellen. Vorzugsweise kann jedoch zwischen dem ersten Empfangssignal 4011 und dem zweiten Empfangssignal 4013 von der Einrichtung 401 zum Erzeugen eine beliebige Phasenbeziehung aufgeprägt werden, so daß die vorbestimmte ersten Phasenbeziehung erzeugt werden kann. Die beiden Empfangssignale 4011 und 4013 werden dann auf der ersten Zwischenfrequenz der Wandlereinrichtung 403 zum Analog-Digital-Wandeln zugeführt. Die Wandlereinrichtung 403 kann beispielsweise jeweils einen Analog-Digital-Wandler für jeden Pfad aufweisen. Alternativ dazu ist es jedoch denkbar, daß die Analog-Digital-Wandlung mit Hilfe eines Analog-Digital-Wandlers durchgeführt wird, der hierzu geeignet getaktet und angesteuert wird. Bei einer Verwendung von zwei Analog-Digital-Wandlern wird unter einer Einhaltung des Abtasttheorems jeweils eine digitale Darstellung 4031 und eine digitale Darstellung 4033 des ersten Empfangssignals 4011 und des zweiten Empfangssignals 4013 erzeugt. Wird beispielsweise nur ein Analog-Digital-Wandler verwendet, so ist es beispielsweise möglich, den Analog-Digital-Wandler abwechselnd mit dem ersten Empfangssignals 4011 und mit dem zweiten Empfangssignals 4013 anzusteuern, was beispielsweise mit Hilfe eines analogen Multiplexers realisiert werden kann. Weist der Analog-Digital-Wandler eine genügend hohe Abtastrate, beispielsweise eine mehrfach so hohe Abtastrate, wie sie zur Einhaltung des Abtasttheorems benötigt wird, so können an dem Ausgang des Analog-Digital-Wandlers die digitale Darstellung 4031 des ersten Empfangssignals 4011 und die digitale Darstellung 4033 des zweiten Empfangssignals 4013 stets erhalten werden.

Da nach der Umsetzung des Empfangssignals auf die erste Zwischenfrequenz und nach der Analog-Digital-Wandlung digitale Signale vorliegen, können die Phasendetektionseinrichtung 405, die erste Mischereinrichtung 407, die Mischeransteuereinrichtung 411, die zweite Mischereinrichtung 409 sowie die Summationseinrichtung 413 digital ausgeführt werden. In diesem Fall wird die digitale Darstellung 4031 des ersten Empfangssignals 4011 und die digitale Darstellung 4033 des zweiten Empfangssignals durch eine digitale Mischung auf eine zweite Zwischenfrequenz umgesetzt. Die digitale Mischung wird durch die erste Mischereinrichtung 407 und durch die zweite Mischereinrichtung 409 realisiert. Zur Umsetzung der Signale 4031 und 4033 auf die zweite Zwischenfrequenz werden die erste Mischereinrichtung 407 und die zweite Mischereinrichtung 409 von der Mischeransteuereinrichtung 411 mit digitalen Ansteuersignalen 4111 und 4113 angesteuert. Da das erste Ansteuersignal 4111 und das zweite Ansteuersignal 4113 digital sind, kann eine erste Frequenz, die das erste Ansteuersignal 4111 und das zweite Ansteuersignal 4113 aufweisen, von der Mischeransteuereinrichtung 411 genau eingestellt werden. Darüber hinaus können die Ansteuersignale 4111 und 4113 von der Mischeransteuereinrichtung 411 derart erzeugt werden, daß sie eine vorbestimmte erste Phasendifferenz aufweisen, die genau eingestellt werden kann. Durch die digitale Umsetzung der Signale 4031 und 4033 sowie durch die digitale Ansteuerung der ersten Mischereinrichtung 407 und 409 kann den beiden Mischerausgangssignalen stets die Eigenschaft aufgeprägt werden, daß nach dem Summieren der beiden Ausgangssignale durch die Summationseinrichtung 413 eine genaue Spiegelfrequenzunterdrückung stattfindet. Voraussetzung hierzu ist jedoch, daß eine Fehlanpassung zwischen den Empfangssignalen 4011 und 4013 und eine Fehlanpassung zwischen der digitalen Darstellung 4031 des ersten Empfangssignals 4011 und der digitalen Darstellung 4033 des zweiten Empfangssignals 4013 reduziert werden. Dies bedeutet insbesondere, daß die beiden Ausgangssignale der ersten Mischereinrichtung 407 und der zweiten Mischereinrichtung 409 eine vorbestimmte zweite Phasenbeziehung zueinander aufweisen, so daß durch die Summation eine optimale Spiegelfrequenzunterdrückung stattfindet. Sind beispielsweise die Spiegelfrequenzsignalanteile, die unterdrückt werden sollen, nicht exakt um 180 Grad gegeneinander verschoben, so werden sie nach der Summation durch die Summationseinrichtung 413 nicht vollständig ausgelöscht, so daß das Ausgangssignal störende Spiegelfrequenzsignalanteile aufweisen kann.

Um die zur Auslöschung von Spiegelfrequenzanteilen notwendige zweite Phasenbeziehung der Ausgangssignale der ersten und der zweiten Mischereinrichtung 407 und 409 einzustellen, ist es zunächst notwendig, daß sowohl die erste Frequenz als auch die erste Phasendifferenz des ersten und des zweiten Ansteuersignals 4111 und 4113, die von der Mischeransteuereinrichtung 411 erzeugt werden, genau eingestellt wird. Um die gewünschte erste Phasenbeziehung der beiden Mischerausgangssignale einzustellen, wird von der Phasendetektionseinrichtung 405 zunächst eine Phase der digitalen Signale 4031 und 4033 auf der ersten Zwischenfrequenz erfaßt. Erfindungsgemäß kann jedoch die Phasendetektionseinrichtung 405 derart ausgeführt werden, daß eine Phasenverschiebung zwischen den beiden digitalen Signalen 4031 und 4033 auf der ersten Zwischenfrequenz algorithmisch erfaßt wird. Um entweder die jeweilige Phase der Signale 4031 und/oder 4033 oder die Phasenverschiebung zwischen den beiden Signalen 4031 und 4033 zu erfassen, kann beispielsweise der bereits erwähnte CORDIC-Algorithmus eingesetzt werden. Der CORDIC-Algorithmus erlaubt es, eine Mehrzahl von mathematischen Operationen, wie beispielsweise Divisionen, Multiplikationen oder eine Berechnung von beliebigen trionometrischen Funktionen zu berechnen, indem die zu berechnende mathematische Operation mit Hilfe von Vektor-Rotationen durchgeführt wird.

In Abhängigkeit von der Phase der digitalen Signale 4031 und 4033 bzw. von deren Phasenverschiebung steuert die Phasendetektionseinrichtung 4033 die Einrichtung 401 zum Erzeugen derart, daß das erste Empfangssignal 4011 und das zweite Empfangssignal 4013, die in diesem Ausführungsbeispiel analog sind, die erste Phasenbeziehung zueinander aufweisen, so daß unter einer Beachtung von möglichen Laufzeitdifferenzen die zur Spiegelfrequenzunterdrückung notwendige zweite Phasenbeziehung der Mischerausgangssignale erzielt wird. Die Phasendetektionseinrichtung 405 steuert ferner die Mischeransteuereinrichtung 411, um sowohl die erste Frequenz des ersten und des zweiten Ansteuersignals 4111 und 4113 genau einzustellen, so daß die digitalen Signale 4031 und 4033 exakt auf die zweite Zwischenfrequenz umgesetzt werden. Die Phasendetektionseinrichtung 405 steuert die Mischansteuereinrichtung 411 ferner derart, daß die Ansteuersignale 4111 und 4113 die erste Phasendifferenz aufweisen, so daß nach der Summation der beiden Mischerausgangssignale die Spiegelfrequenzunterdrückung erzielt werden kann. Ist beispielsweise die Phasenverschiebung der digitalen Signale 4031 und 4033 auf der ersten Zwischenfrequenz zu gering, um eine optimale Spiegelfrequenzunterdrückung zu erreichen, so wird die Einrichtung 401 von der Phasendetektionseinrichtung 405 derart angesteuert, daß eine Phasenverschiebung zwischen dem ersten Empfangssignal 4011 und dem zweiten Empfangssignal 4013 vergrößert wird. Ist hingegen die Phasenverschiebung zwischen den digitalen Signalen 4031 und 4033 zu groß, so wird die Einrichtung 401 derart angesteuert, daß die Phasenverschiebung zwischen dem ersten Empfangssignal 4011 und dem zweiten Empfangssignal 4013 verkleinert wird.

Die Phasendetektionseinrichtung 405 kann ferner ausgehend von der Phasenverschiebung zwischen den digitalen Signalen 4031 und 4033 die Einrichtung 401 derart ansteuern, daß das erste und das zweite Empfangssignal 4011 und 4013 exakt auf die erste Frequenz umgesetzt werden, so daß keine Frequenzverschiebung auftritt. Da die Empfangssignale 4011 und 4013 mit Hilfe von Analogkomponenten umgesetzt werden, ist eine genügend genaue Einstellung der ersten Phasenbeziehung des ersten und des zweiten Empfangssignals 4011 und 4013 zueinander nicht möglich. Darüber hinaus ist eine exakte Einhaltung der ersten Zwischenfrequenz nicht möglich. Diese Fehlanpassungen können jedoch digital korrigiert werden, indem die Phasendetektionseinrichtung 405 die Mischeransteuereinrichtung 411 derart ansteuern, daß die Ansteuersignale 4111 und 4113 die gewünschte erste Phasendifferenz und die erste Frequenz aufweisen, so daß etwaige Fehlanpassungen auf der Analogseite an den Ausgängen der Mischereinrichtungen 407 und 409 kompensiert werden.

In dem in Fig. 4 dargestellten Ausführungsbeispiel der erfindungsgemäßen Vorrichtung zum Abwärtsmischen wurde einer übersichtlichkeitshalber angenommen, daß sowohl die erste Mischereinrichtung als auch die zweite Mischereinrichtung keine zusätzliche Phasenverschiebung der Ausgangssignale auf der zweiten Zwischenfrequenz verursachen. Ist es nicht der Fall, so kann die Phasendetektionseinrichtung 405 erfindungsgemäße ferner beispielsweise eine Phase der beiden Mischerausgangssignale oder deren Phasenverschiebung zueinander erfassen. Dies kann kostengünstig realisiert werden, da die beiden Mischerausgangssignale ohnehin digital sind. Falls die erste Mischereinrichtung und/oder die zweite Mischereinrichtung eine zusätzliche Phasenverschiebung verursachen, so kann die zweite Phasenbeziehung der Ausgangssignale der ersten und der zweiten Mischereinrichtung digital mit Hilfe einer weiteren Einrichtung, die in dem in Fig. 4 dargestellten Ausführungsbeispiel nicht eingezeichnet ist, genau eingestellt werden. Dies kann beispielsweise digital dadurch realisiert werden, daß die beiden Mischerausgangssignale geeignet verzögert werden.

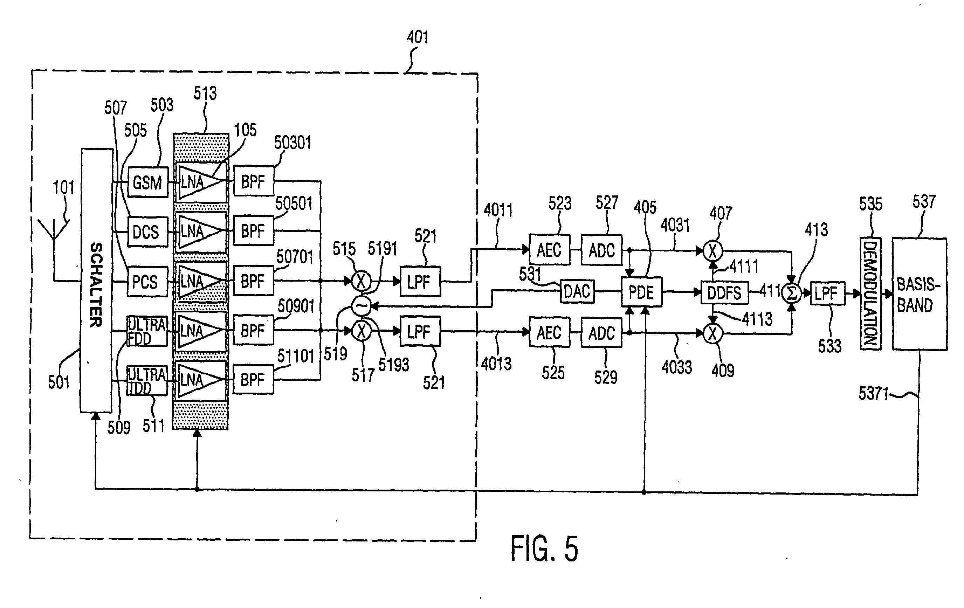

In Fig. 5 ist ein weiteres Ausführungsbeispiel eine Vorrichtung zum Abwärtsmischen gemäß der vorliegenden Erfindung dargestellt.

Die Einrichtung 401 zum Erzeugen des ersten Empfangssignals 4011 und des zweiten Empfangssignals 4013 auf der ersten Zwischenfrequenz umfaßt in dem in Fig. 5 dargestellten Ausführungsbeispiel die Antenne 101, deren Ausgang mit einem Schalter 501 (switch) gekoppelt ist. Der Schalter 501 weist eine Mehrzahl von Ausgängen, die jeweils mit einem Bandpaßfilter verbunden sind. In dem in Fig. 5 dargestellten Ausführungsbeispiel werden die Ausgangssignale des Schalters 501 einem GSM-Bandpaßfilter 503, einem DCS-Bandpaßfilter 505, einem PCS-Bandpaßfilter 507, einem Ultra-FDD-Bandpaßfilter 509 sowie einem Ultra-TDD-Bandpaßfilter 511 zugeführt. Die Ausgangssignale der Bandpaßfilter 503-511 werden durch einen Verstärkungsblock 513 verstärkt. Der Verstärkungsblock 513 weist jeweils einen LNA 105 zum Verstärken eines jeweiligen Filterausgangssignals auf. Die jeweiligen Ausgänge der LNAs 105 sind mit Bandpaßfiltern gekoppelt. Dabei ist ein zu dem GSM-Bandpaßfilter 503 zugehöriger Zweig mit einem Bandpaßfilter 50301 gekoppelt, ein zu dem DCS-Bandpaßfilter 505 zugehöriger Zweig mit einem Bandpaßfilter 50501 gekoppelt, ein zu dem PCS-Bandpaßfilter 507 zugehöriger Zweig mit dem Bandpaßfilter 50701 gekoppelt, ein zu dem Ultra-FDD-Bandpaßfilter 509 zugehöriger Zweig mit einem Bandpaßfilter 50901 gekoppelt und ein dem Ultra-TDD-Bandpaßfilter 511 zugehöriger Zweig mit einem Bandpaßfilter 51101 gekoppelt. Die jeweiligen Ausgänge der jeweiligen Bandpaßfilter 50301-51101 sind miteinander verbunden. Ein Filterausgangssignal wird dann verzweigt und die Verzweigungssignale werden einer dritten Mischereinrichtung 505 sowie einer vierten Mischereinrichtung 517 zugeführt. Die Mischereinrichtung 515 und die Mischereinrichtung 517 sind in dem in Fig. 5 dargestellten Ausführungsbeispiel als analoge Mischer ausgeführt. Zum Ansteuern der Mischer 515 und 517 wird ein steuerbarer Lokaloszillator 519 verwendet, der ein drittes Ansteuersignal 5191 und ein viertes Ansteuersignal 5193 erzeugt. Die Ausgangssignale der Mischer 515 und 517 werden durch die Tiefpaßfilter 521 tiefpaßgefiltert, so daß an einem jeweiligen Filterausgang das erste Empfangssignal 4011 und das zweite Empfangssignal 4013 auf der ersten Zwischenfrequenz vorliegen. Das erste Empfangssignal 4011 wird einem ersten Verstärkungscontroller 523 zugeführt, das zweite Empfangssignal 4013 wird einem zweiten Verstärkungscontroller 525 zugeführt. Ein Ausgangssignal des ersten Verstärkungscontrollers 523 (AGC; AGC = automatic gain control) wird einem ersten Analog-Digital-Wandler (ADC; ADC = analog digital converter) 527 zugeführt. Ein Ausgangssignal des zweiten Verstärkungscontrollers 525 wird einem zweiten Analog-Digital-Wandler 529 zugeführt. Der erste Analog-Digital-Wandler 527 liefert die digitale Darstellung 4031 des ersten Empfangssignals 4011, der zweite Analog-Digital-Wandler 529 liefert die digitale Darstellung 4033 des zweiten Empfangssignals 4013. Das digitale Signal 4031 wird der ersten Mischereinrichtung 407 zugeführt, das digitale 4033 wird der zweiten Mischereinrichtung 409 zugeführt. Sowohl die erste Mischereinrichtung 407 als auch die zweite Mischereinrichtung 409 sind in dem in Fig. 5 dargestellten Ausführungsbeispiel als digitale Mischer ausgeführt. Die digitalen Signale 4031 und 4033 werden ferner der Phasendetektionseinrichtung (PDE) 405 zugeführt. Ein Ausgang der Phasendetektion 405 ist mit einem Digital-Analog-Konverter 531 gekoppelt, dessen Ausgangssignal den steuerbaren Lokaloszillator 519 ansteuert. Ein weiterer Ausgang der Phasendetektionseinrichtung 405 ist mit der Mischeransteuerungseinrichtung 411 verbunden, die in diesem Ausführungsbeispiel als ein direkter digitaler Frequenzsynthesizer (DDFS; DDFS = direct digital frequency synthesizer) ausgeführt ist. Der DDFS 411 liefert das erste Ansteuersignal 4111 zum Ansteuern der ersten Mischereinrichtung 407 und das zweite Ansteuersignal 4113 zum Ansteuern der zweiten Mischereinrichtung 409. Die digitalen Mischerausgangssignale werden der Summationseinrichtung 413 zugeführt. Ein Ausgangssignal der Summationseinrichtung 413 wird mit Hilfe eines Tiefpaßfilters 533 (LPF; LPF = low pass filter) tiefpaßgefiltert und einem Demodulator 535 zugeführt. Die Ausgangssignale des Demodulators 535 werden einem Basisbandblock 537 zugeführt. Der Basisbandblock 537 liefert ferner ein Steuersignal 5371, das von der Phasendetektionseinrichtung 405, von dem Verstärkungsblock 513 sowie von dem Schalter 501 empfangen wird.

Im folgenden wird die Funktionsweise des in Fig. 5 dargestellten Ausführungsbeispiels eine Vorrichtung zum Abwärtsmischen gemäß der vorliegenden Erfindung erläutert.

Gemäß dem in Fig. 5 dargestellten Ausführungsbeispiel ist die dort gezeigte Vorrichtung zum Abwärtsmischen ausgebildet, um Multistandard-Empfangssignale zu empfangen und zu verarbeiten. Da sich die unterschiedlichen Standards, wie GSM, DCS oder PCS durch unterschiedliche Trägerfrequenzen auszeichnen, wird ein über die Antenne 101 empfangenes Signal mit Hilfe des Schalters 501 auf eines der Bandpaßfilter 503-511 durchgeschaltet, wenn das empfangene Signal einem der in Fig. 5 beispielhaft berücksichtigten MobilfunkStandards entspricht. Wird beispielsweise ein Signal empfangen, das ein GSM-Signal ist, so wird der Schalter 501 von dem Basisbandblock 537 derart angesteuert, daß das über die Antenne 101 empfangene Signal auf das GSM-Bandpaßfilter 503 geschaltet wird. Das bandpaßgefilterte Signal wird sodann dem Verstärkungsblock 513 zugeführt und durch den LNA 105 verstärkt. Nach einer anschließenden Bandpaßfilterung durch das Bandpaßfilter 50301 wird ein so entstandenes Signal verzweigt und mit Hilfe der Mischer 515 und 517 auf die erste Zwischenfrequenz umgesetzt, wobei die Tiefpaßfilter 521 die Signale auf der ersten Zwischenfrequenz durchlassen und die höherfrequenten Signalanteile unterdrücken. Zur Umsetzung der Bandpaßfilterausgangssignale werden die Mischer 515 und 517 durch das dritte und das vierte Ansteuersignal 5191 und 5193 angesteuert. Beide Ansteuersignale werden durch den Lokaloszillator 519 erzeugt, und weisen neben einer zweiten Frequenz, die durch eine Oszillationsfrequenz festgelegt ist, eine zweite Phasendifferenz auf, die mit Hilfe eines steuerbaren Phasenschiebers, der ein Bestandteil des Lokaloszillators 519 sein kann und in Fig. 5 nicht dargestellt ist, eingestellt werden kann. Das erste Empfangssignal 4011 und das zweite Empfangssignal 4013, die nach der Tiefpaßfilterung durch die Filter 521 entstehen, werden jeweils dem ersten AGC 523 und dem zweiten AGC 525 zugeführt. Die Verstärkungscontroller 523 und 525 haben die Aufgabe, eine Fehlanpassung des ersten Empfangssignals 4011 und des zweiten Empfangssignals 4013 bezüglich einer Amplitude auszugleichen und/oder um die beiden Eingangssignale 4011 und 4013 derart zu verstärken, daß sowohl der erste Analog-Digital-Wandler 527 als auch der zweite Analog-Digital-Wandler 529 genügend ausgesteuert werden, so daß die Wandlereingangssignale an die Wandler angepaßt werden. Nach der Analog-Digital-Wandlung durch die Wandler 527 und 529 entstehen die digitalen Signale 4031 und 4033 auf der ersten Zwischenfrequenz. Die Phasendetektionseinrichtung 405 erfaßt dabei entweder die Phase der digitalen Signale 4031 und 4033 oder die Phasenverschiebung zwischen derselben, um den Lokaloszillator 519 derart anzusteuern, daß das dritte Ansteuersignal 5191 und das vierte Ansteuersignal 5193 die zweite Frequenz sowie eine zweite Phasendifferenz aufweisen, so daß das erste Empfangssignal 4011 und das zweite Empfangssignal 4013 die erste Phasenbeziehung zueinander aufweisen, die zu einer optimalen Unterdrückung der Spiegelfrequenz notwendig ist. Da die Phasendetektionseinrichtung 405 zeitdiskret aufgebaut ist, wird das Ausgangssignal, das den Lokaloszillator 519 steuert, mit Hilfe des Digital-Analog-Wandlers 531 in einen zeitkontinuierlichen Bereich überführt.

Zum Anpassen der Amplituden des ersten und des zweiten Empfangssignals 4011 und 4013 kann die Phasendetektionseinrichtung 405 ferner die Amplituden der beiden digitalen Signale 4031 und 4033 erfassen und auf der Basis dieser Amplitudenerfassung den ersten Verstärkungscontroller 523 und den zweiten Verstärkungscontroller 525 derart ansteuern, daß eine Amplitudenfehlanpassung eliminiert ist.

Die digitalen Signale 4031 und 4033 werden durch eine digitale Mischung, die mit Hilfe der Mischer 407 und 409 durchgeführt wird, auf die zweite Zwischenfrequenz umgesetzt. Der DDFS 411 synthetisiert dabei digital das erste Ansteuersignal 4111, das den Mischer 407 ansteuert, und das zweite Ansteuersignal 4113, das den zweiten Mischer 409 ansteuert. Sowohl die erste Frequenz als auch die erste Phasendifferenz der Ansteuersignale 4111 und 4113 werden in Abhängigkeit von der Phase der digitalen Signale 4031 und 4033 oder von deren Phasendifferenz eingestellt, indem die Mischeransteuerungseinrichtung 411 von der Phasendetektionseinrichtung 405 angesteuert wird, wie es bereits im Zusammenhang mit dem in Fig. 4 dargestellten Ausführungsbeispiel erläutert worden ist. Da es sich bei den Mischern 407 und 409 um digitale Mischer handelt, werden die digitalen Signale 4031 und 4033 durch eine digitale Multiplikation mit den Ansteuersignalen 4111 und 4113 auf die zweite Zwischenfrequenz umgesetzt. Dadurch, daß die Phasendetektionseinrichtung 405 sowohl den Lokaloszillator 519 als auch die Mischeransteuereinrichtung 411 ansteuert, können die Spiegelfrequenzanteile durch eine Summation der Ausgangssignale der Mischer 407 und 409, die vorzugsweise digital durchgeführt wird, unterdrückt werden. Nach einer Tiefpaßfilterung durch den Filter 533 wird ein so entstandenes Einseitenbandsignal in dem Demodulator 535 demoduliert und in dem Basisbandblock 537 einer weiteren Basisbandbearbeitung unterzogen. Dabei können beispielsweise die demodulierten Signale detektiert und decodiert werden.

Um die Vorteile einer digitalen Signalverarbeitung ausnutzen zu können, wäre es wünschenswert, eine extrem niedrige erste Zwischenfrequenz zu erhalten, was beispielsweise mit der in Fig. 3 bereits diskutierten Weaver- Struktur möglich ist. Die Effekte der Phasen- und Amplitudenabweichungen zwischen den Empfangssignalen 4011 und 4013 sind jedoch analog nur mit einem erheblichen Aufwand zu reduzieren. Dieses Problem wird erfindungsgemäß dadurch gelöst, daß Teile der erfindungsgemäßen Vorrichtung zum Abwärtsmischen digital ausgeführt sind. Hierbei wird durch eine geschickte Analog/Digital-Partitionierung eine weitere Möglichkeit zu einer hochpräzisen Spiegelfrequenzunterdrückung gegeben.

Die Digitalisierung der Signale erfolgt zwischen den Mischern 515, 519 und 407 und 409. Um die Analog-Digital-Wandler geeignet ansprechen zu können, werden die automatischen Verstärkungscontroller (AGC) eingesetzt. Diese passen das Eingangssignal an die Wandler an, so daß die Analog-Digital-Wandler geeignet ausgesteuert werden. Hierdurch wird ein verringerter Eingangsbereich erreicht. Die anschließende Digitalisierung erfordert eine geringe Zwischenfrequenz, damit die Empfangssignale 4011 und 4013 unter Einhaltung des Abtasttheorems abgetastet werden können. Vorzugsweise weist die erste Zwischenfrequenz einige Megahertz auf. Es sind aber durchaus geringere erste Zwischenfrequenzen denkbar. In jedem Fall sollen die Empfangssignale 4011 und 4013 überabgetastet werden, da einerseits die Empfangsfilter als auch beispielsweise eine 90 Grad-Phasenverschiebung zwischen den Empfangssignalen 4011 und 4013, die in diesem Falle als eine I- und eine Q-Komponente interpretiert werden können, auflösbar sein muß. Die anschließenden Schritte können nun digital durchgeführt werden. Dies macht eine Multiplikation, die zu der Umsetzung der digitalen Signale 4031 und 4033 auf die zweite Zwischenfrequenz benötigt wird, ohne Fehler möglich. Eine Phasen- oder Amplitudenabweichung ist somit nicht vorhanden. Neben den Vorteilen einer fehlerfreien Weiterverarbeitung kann nun mit einem geeignet gewählten Algorithmus, beispielsweise dem bereits erwähnten CORDIC-Algorithmus, eine Berechnung der Amplitude, der Phase und der Frequenz der digitalen Signale 4031 und 4033 digital durchgeführt werden. Dies hat einen entscheidenden Vorteil, daß die angesprochenen Fehler rückberechnet und kompensiert werden können.

Wird die in Fig. 5 dargestellte Vorrichtung zum Abwärtsmischen eingesetzt, um Multistandardsignale zu empfangen, so erstreckt sich der zu verarbeitende Frequenzbereich beispielsweise von 890 MHz bis 2480 MHz. Um eine Möglichkeit zu haben, zwischen den unterschiedlichen Empfangsbändern zu wählen, wird vorzugsweise hinter dem Antennenausgang der Schalter 501 (Multiplexer) angeordnet. Hierzu gibt es verschiedene Ansatzmöglichkeiten. Der Schalter 501 kann beispielsweise als ein herkömmlicher Schalter ausgewählt werden. Um die Komfort- und Umschaltzeitspezifikationen einzuhalten, empfiehlt es sich beispielsweise, einen sogenannten mikromechanischen Schalter einzusetzen, wie er in der folgenden Schrift offenbart ist: C. Nguyen: Micromechanical components for miniaturisized low power communications, IEEE MTT-S 1999. Weiterhin kann für diese Aufgabe ein abstellbares Filter gewählt werden. Welche Möglichkeiten einer Ausführung des Schalters 501 in Betracht gezogen werden, muß gewährleistet werden, daß vorzugsweise nur ein Empfangspfad gleichzeitig gewählt wird. Würde man zwei Pfade parallel schalten, so würde man die Leistung um 3 dB verringern. Dies ist bei Mobilfunkanwendungen nicht akzeptabel. Falls mehrere Pfade parallel geschaltet werden sollten, so müßten noch weitere geeignete Verstärker geschaltet werden, um den Leistungsverlust auszugleichen. Das durch den LNA 105 verstärkte Signal wird nochmals bandpaßgefiltert, um die harmonischen Schwingungen, die beispielsweise durch Nicht-Linearitäten in dem LNA 105 verursacht werden, herauszufiltern. Anschließend wird das Signal heruntergemischt wobei die Mischer 515 und 517 in einem weiten Spektralbereich realisiert werden müssen. Falls dies kostengünstig nicht erzielt werden kann, so ist es möglich, beispielsweise den GSM-Frequenzbereich und die restlichen Bänder (über 1800 MHz) getrennt zu verarbeiten.

Die beiden digitalen Signale 4031 und 4033 werden mit Hilfe der digitalen Mischung durch die Mischer 407 und 409 auf die zweite Zwischenfrequenz umgesetzt, die von der ersten Frequenz der Ansteuersignale 4111 und 4113 abhängig ist. Wird die zweite Zwischenfrequenz derart gewählt, daß die digitalen Signale 4031 und 4033 nicht in ein Basisband verschoben werden, so entsteht nach der Summation durch die Summationseinrichtung 413 ein Einseitenbandsignal, das keine Gleichanteile aufweist. Alternativ dazu können die digitalen Signale 4031 und 4033 mit Hilfe der digitalen Mischer 407 und 409 direkt in das Basisband umgesetzt werden, so daß dem Demodulator 535 bereits ein Basisbandsignal zur Verfügung gestellt wird.

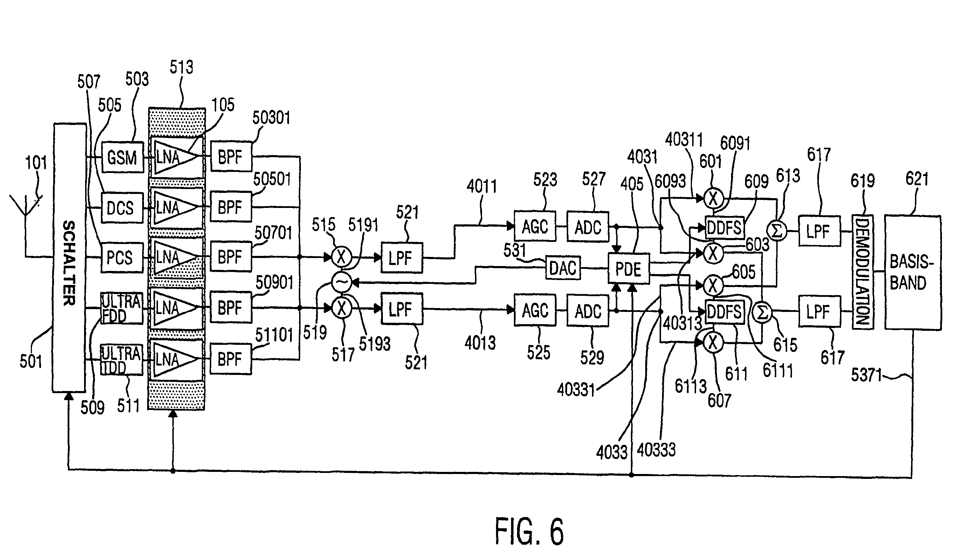

In Fig. 6 ist ein weiteres Ausführungsbeispiel einer Vorrichtung zum Abwärtsmischen gemäß der vorliegenden Erfindung dargestellt.

Im Unterschied zu dem in Fig. 5 dargestellten Ausführungsbeispiel wird die digitale Darstellung 4031 des ersten Empfangssignals 4011 in zwei Pfade aufgeteilt. Ein erster Pfad 40311 ist mit einem fünften Mischer 601 verbunden. Ein zweiter Pfad 40313 ist mit einem sechsten Mischer 603 verbunden. Die digitale Darstellung 4033 des zweiten Empfangssignals 4013 wird ebenfalls in zwei Pfade aufgeteilt. Ein dritter Pfad 40331 ist mit einem siebten Mischer 605 verbunden. Ein vierter Pfad 40333 ist mit einem achten Mischer 607 verbunden. Der fünfte Mischer 601 und der sechste Mischer 603 werden von einem ersten DDFS 609 angesteuert. Dabei erzeugt der DDFS 609 ein fünftes Ansteuersignal 6091 zum Ansteuern des Mischers 601 sowie ein sechstes Ansteuersignal 6093 zum Ansteuern des sechsten Mischers 603. Der siebte Mischer 605 und der achte Mischer 607 werden von einem zweiten DDFS 611 angesteuert. Dabei erzeugt der zweite DDFS 611 ein siebtes Ansteuersignal 6111 zum Ansteuern des siebten Mischers 605 und ein achtes Ansteuersignal 6113 zum Ansteuern des achten Mischers 607. Die Ausgangssignale des fünften Mischers 601 und des siebten Mischers 605 werden mit Hilfe einer ersten Summationseinrichtung 613 summiert. Die Ausgangssignale des sechsten Mischers und des achten Mischers werden mit Hilfe einer zweiten Summationseinrichtung 615 summiert. Ein Ausgangssignal der Summationseinrichtung 613 und ein Ausgangssignal der Summationseinrichtung 615 werden mit Hilfe von Tiefpaßfiltern (LPF) 617, die vorzugsweise eine identische Charakteristik aufweisen, gefiltert. Die jeweiligen Ausgangssignale der Tiefpaßfilter werden einem Demodulator 619 zugeführt. Ein Ausgangssignal des Demodulators 619 wird einem Basisbandblock 621 zugeführt.

Im folgenden wird die Funktionsweise des in Fig. 6 dargestellten Ausführungsbeispiels einer Vorrichtung zum Abwärtsmischen erläutert. Dabei wird auf Funktionalitäten, die bereits im Zusammenhang mit dem in Fig. 5 dargestellten Ausführungsbeispiel bereits erklärt worden sind, nicht erneut eingegangen.

Die digitalen Signale 4031 und 4033 sind Zwischenfrequenzsignale auf der ersten Frequenz, die aus der Umsetzung des Empfangssignals durch die Mischer 515 und 517 herrühren. Erfindungsgemäß werden die digitalen Signale auf der ersten Zwischenfrequenz durch digitale Mischung mit Hilfe der Mischer 601, 603, 605 und 607 in ein Basisband überführt, so daß die informationstragenden I- und Q-Basisbandsignale direkt ausgegeben werden. Nach einer Verzweigung des digitalen Signals 4031 wird der erste Pfad 40311 dem digitalen Mischer 601 zugeführt, und der zweite Pfad 40313 wird dem digitalen Mischer 603 zugeführt. Das Mischerpärchen (601, 603) wird durch den ersten DDFS 609, der von der PDE 405 steuerbar ist, angesteuert. Der DDFS 609 erzeugt dabei das fünfte und das sechste Ansteuersignal 6091 und 6093, wobei die Ansteuersignale 6091 und 6093 eine bestimmte Frequenz und eine bestimmte Phasendifferenz zueinander aufweisen. Die Frequenz der Ansteuersignale 6091 und 6093 wird derart gewählt, daß die Ausgangssignale der Mischer 601 und 603 jeweils einen Signalanteil im Basisband aufweisen. Die Mischung durch die digitalen Mischer 601 und 603 erfolgt digital durch eine Multiplikation der den Pfaden 40311 und 40313 zugehörigen digitalen Signale mit den digitalen Ansteuersignalen 6091 und 6093. Analog werden die den Pfaden 40331 und 40333 zugehörige Signale mit Hilfe des siebten Mischers und des achten Mischers 605 und 607 umgesetzt. Der siebte Mischer 605 und der achte Mischer 607 werden jeweils von dem siebten Ansteuersignal 6111 und dem achten Ansteuersignal 6113 angesteuert, wobei die Ansteuersignale 6111 und 6113 von dem DDFS 611 erzeugt werden. Dabei weist das siebte und das achte Ansteuersignal 6111 und 6113 eine vorbestimmte Frequenz und eine vorbestimmte Phasendifferenz zueinander, so daß die Ausgangssignale der Mischer 605 und 607 ein Signalanteil im Basisband aufweisen. Handelt es sich bei dem dritten Ansteuersignal 5191 um ein Cosinussignal und handelt es sich bei dem vierten Ansteuersignal 5193 um ein Sinussignal, so weist die digitale Darstellung 4031 des Empfangssignals 4011 einen Cosinusanteil auf der ersten Zwischenfrequenz auf und die digitale Darstellung 4033 des zweiten Empfangssignals 4013 weist einen Sinusanteil auf der ersten Zwischenfrequenz auf. Weisen die digitalen Signale 4031 und 4033 eine 90 Grad-Phasenverschiebung zueinander auf, so werden die Mischer 601 und 603 sowie 605 und 607 jeweils mit Ansteuersignalen angesteuert, die ebenfalls 90 Grad phasenverschoben sind. Beispielsweise wird dabei der Mischer 601 mit einem Cosinussignal angesteuert und der Mischer 603 mit einem Sinussignal angesteuert, während der Mischer 605 mit einem Sinussignal und der Mischer 607 mit einem Cosinussignal angesteuert werden. Unter Ausnutzung von trigonometrischen Gesetzmäßigkeiten werden nach einer Addition, die durch die Summationseinrichtungen 613 und 615 bewerkstelligt wird, Basisband-Quadratursignale erzeugt, wobei die Spiegelfrequenzen unterdrückt werden. Nach der Tiefpaßfilterung durch die Filter 617 kann das Signal durch den Demodulator 619 demoduliert werden, so daß in dem Basisbandblock 621 beispielsweise eine anschließende Decodierung und Detektion durchgeführt werden kann. Da sowohl der DDFS 609 als auch der zweite DDFS 611 von der PDE 405 gesteuert werden, können die Phasen der Ansteuersignale 6091, 6093 sowie 6111 und 6113 derart eingestellt werden, so daß die Ausgangssignale der Summationseinrichtungen 613 und 615 spiegelfrequenzanteilfreie Quadratursignale sind. Ähnlich kann die Frequenz dann Steuersignale 6091, 6093 sowie 6111 und 6113 derart eingestellt werden, daß eine genaue Basisbandmischung durchgeführt werden kann. Ein Vorteil der in Fig. 6 dargestellten erfindungsgemäßen Vorrichtung zum Abwärtsmischen besteht darin, daß ein Demodulationsaufwand verringert wird, indem das Signal am Ausgang der Struktur als ein Basisbandsignal vorliegt. Ein weiterer Vorteil dieses Empfängers liegt in einer kalibrierbaren I/O-Fehlanpassung. Darüber hinaus kann durch eine Differenzmessung der orthogonalen Basisbandsignale kann wie auch für die Spiegelfrequenzunterdrückung ferner eine Regelschleife aufgebaut werden, so daß Fehler bei der anschließenden Demodulation verringert werden. Insbesondere eignet sich die in Fig. 6 dargestellte Struktur für einen breitbandigen Empfang, da die Frequenz der Ansteuersignale 6091, 6093, 6111 und 6113 digital und somit genau eingestellt werden kann, so daß eine Anforderung an den Lokaloszillator 519 bezüglich einer Breitbandigkeit entschärft werden kann.

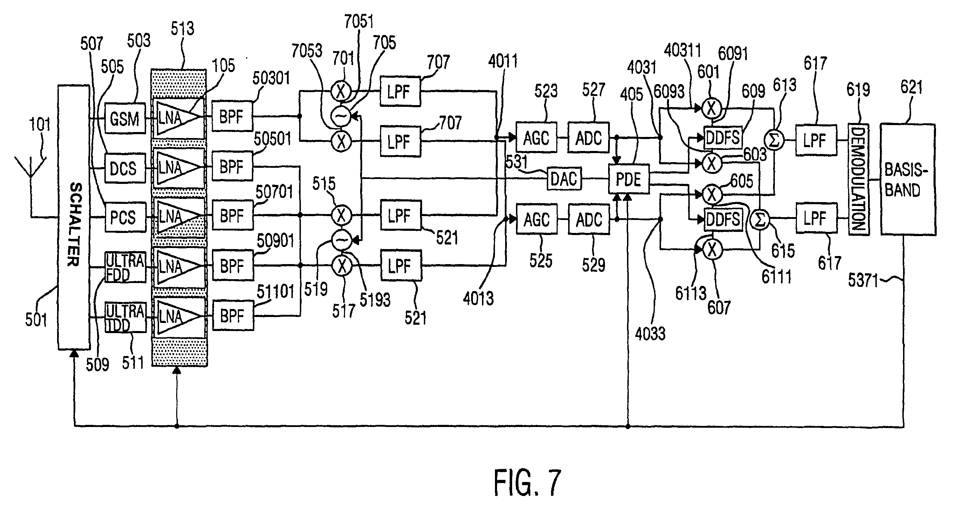

In Fig. 7 ist ein weiteres Ausführungsbeispiel einer Vorrichtung zum Abwärtsmischen gemäß der vorliegenden Erfindung dargestellt. Im Unterschied zu dem in Fig. 6 dargestellten Ausführungsbeispiel wird ein GSM-Empfangssignal separat bearbeitet. Nach der Bandpaßfilterung durch das Filter 50301 wird das hochfrequente GSM-Signal verzweigt und die Verzweigungssignale werden jeweils einem neunten Mischer 701 und einem zehnten Mischer 703 zugeführt. Die Mischer 701 und 703 werden von einem Lokaloszillator 705, der ein neuntes Ansteuersignal 7051 und ein zehntes Ansteuersignal 7053 liefert, angesteuert. Die Ausgangssignale der Mischer 701 und 703 werden jeweils einem Tiefpaßfilter 707 zugeführt.

Die Empfangssignale, die anderen Standards zugeordnet sind, beispielsweise DCS, PCS, Ultra-FDD und Ultra-TDD werden mit Hilfe der Mischeranordnung aus Fig. 7 auf die erste Zwischenfrequenz umgesetzt. Dabei werden sowohl der Lokaloszillator 519 als auch der Lokaloszillator 705 von der PDE 405 gesteuert.

Im folgenden wird die Funktionsweise des in Fig. 7 dargestellten Ausführungsbeispiels der Vorrichtung zum Abwärtsmischen gemäß der vorliegenden Erfindung erläutert.

Ist es nicht möglich, die in Fig. 6 dargestellten Mischer 515 und 517 in einem breiten Frequenzbereich in MOS-Technologie zu realisieren, so wird vorzugsweise der Frequenzbereich beispielsweise für GSM separat ausgeführt und heruntergemischt. In diesem Ausführungsbeispiel werden GSM-Signale separat behandelt, da GSM in einem Frequenzbereich zwischen 935-960 MHz liegt und beispielsweise der DCS-Standard in einem Frequenzbereich zwischen 1805-8880 MHz liegt. Wird der GSM-Pfad separat bearbeitet, so können die Mischer 701 und 703 von Ansteuersignalen 7051 und 7053 angesteuert werden, die von dem Lokaloszillator 705 erzeugt werden. Dabei weist der Lokaloszillator 705 eine Oszillatorfrequenz auf, die von einer Oszillatorfrequenz des Lokaloszillators 519 abweicht, so daß Lokaloszillatoren 705 und 519 nicht hoch breitbandig ausgeführt sein müssen, was zu einer Umsetzung von allen Multistandardsignalen notwendig wäre. Mit Hilfe der in Fig. 7 dargestellten Empfangsstruktur können nun die Lokaloszillatoren 705 und 519 kostengünstiger und stabiler sein.

Soll nun ein GSM-Signal empfangen werden, so liefert der Basisbandblock 621 das Signal 5371, das den Schalter (switch) 501 derart ansteuert, so daß ein über die Antenne 101 empfangenes Signal zu dem GSM-Filter 503 durchgeschaltet wird, während die übrigen Filter 505, 507, 509 und 511 kein Signal empfangen. Das GSM-Empfangssignal wird nach der Verstärkung durch den LNA 105 sowie nach der Bandpaßfilterung durch das Bandpaßfilter 50301 dem Mischerpärchen 701 und 703 zugeführt. Nach der Mischung auf die erste Zwischenfrequenz liegen an den Eingängen der Verstärkungscontroller 523 und 525 die digitalen Signale 4011 und 4013, die aus einer Abwärtsmischung des GSM-Empfangssignals hervorgehen. Der PDE 405 steuert dabei sowohl die Phase als auch die Frequenz der Ansteuersignale 7051 und 7053 in einer analogen Weise, wie die Phase und die Frequenz der Steuersignale 5191 und 5193 gesteuert werden, wie es bereits im Zusammenhang mit dem in Fig. 5 oder in Fig. 6 dargestellten Ausführungsbeispielen erläutert worden ist.

Soll kein GSM-Signal empfangen werden, sondern beispielsweise ein DCS-Signal, so wird der Schalter 501 von dem Signal 5371 derart angesteuert, daß ein über die Antenne 101 empfangenes Signal dem DCS-Bandpaßfilter 505 zugeführt wird, während die anderen Filter 503, 507, 509 und 511 kein Signal empfangen. Da der GSM-Pfad abgetrennt ist, wird nur das DCS-Signal auf die erste Zwischenfrequenz umgesetzt, so daß an den Eingängen der Verstärkungscontroller 523 und 525 die digitalen Signale 4011 und 4013 anliegen, die jeweils eine digitale Darstellung des DCS-Empfangssignals sind.

Zum Abwärtsmischen der verschiedenen Multistandard-Signale kann zu einer Umsetzung dieser Signale auf die erste Zwischenfrequenz beispielsweise die Oszillatorfrequenz des Oszillators 519 variiert werden, so daß die Empfangssignale auf die erste Zwischenfrequenz, die beispielsweise fest vorgegeben sein kann, umgesetzt werden. Hierzu sollte die Oszillatorfrequenz geeignet kalibriert werden, bevor ein gewünschtes Multistandard-Signal, beispielsweise ein Ultra-TDD-Signal, empfangen wird. Um eine Frequenzauswahl zu treffen, d. h. um eine geeignete Oszillationsfrequenz von beispielsweise dem Lokaloszillator 519, wie er in Fig. 7 dargestellt ist, einzustellen, kann die in Fig. 7 dargestellte Empfangsstruktur entweder vor einem Empfangen eines Signals kalibriert werden. Diese Kalibrierung kann jedoch auch während der leeren Zeitschlitze, die stets in Verbindung mit einem TDMA-Betrieb entstehen (TDMA; TDMA = time devision multiple access) durchgeführt werden.

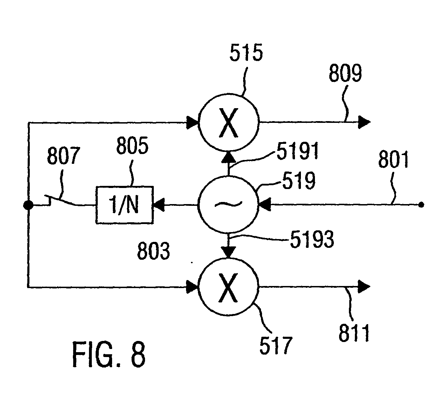

In Fig. 8 ist ein weiteres Ausführungsbeispiel einer Frequenzauswahleinrichtung gemäß der vorliegenden Erfindung dargestellt. Die Frequenzausfalleinrichtung umfaßt in diesem Ausführungsbeispiel den dritten Mischer 515 und den vierten Mischer 517 die, wie es bereits im Zusammenhang mit dem in Fig. 7 dargestellten Ausführungsbeispiel diskutiert worden ist, von dem dritten Ansteuersignal 5191 und von dem vierten Ansteuersignal 5193 angesteuert werden. Der Lokaloszillator 519 wird von einem Signal 801 gesteuert. Darüber hinaus liefert der Lokaloszillator 519 ein Frequenzsignal 803, das einem Frequenzteiler 805 zugeführt wird. Darüber hinaus weist wie in Fig. 8 dargestellte Frequenzausfalleinrichtung einen Schalter 807 auf, der ein Ausgangssignal des Frequenzteilers 805 auf die Mischer 515 und 517 durchschaltet oder nicht durchschaltet.

Im folgenden wird die Funktionsweise des in Fig. 8 dargestellten Ausführungsbeispiels der Frequenzauswahleinrichtung erläutert.

Wird der steuerbare Lokaloszillator 519 mit dem Steuersignal 801 angesteuert, so liefert der Lokaloszillator 519 das Frequenzsignal 803, dessen Frequenz von einer Oszillationsfrequenz des Oszillators 519 abhängig ist, die durch das Steuersignal 801 eingestellt werden kann. Das Frequenzsignal 803 wird dann dem Frequenzteiler 805 zugeführt. Gemäß dem in Fig. 8 dargestellten Ausführungsbeispiel liefert der Frequenzteiler 805 das Ausgangssignal, dessen Frequenz um einen Faktor N geringer als die Frequenz des Frequenzsignals 803 ist. Wird nun der Schalter 807 geschlossen, so wird das Ausgangssignal des Frequenzteilers 805 den Mischern 515 und 517 zugeführt. Da die Mischer 515 und 517 durch die Ansteuersignale 5191 und 5193 angesteuert sind, findet nun eine Mischung des Ausgangssignals des Frequenzteilers 805 mit dem dritten Ansteuersignal 5191 und mit dem vierten Ansteuersignal 5193 statt. Die Mischer 515 und 517 liefern dabei die Ausgangssignale 809 und 811, die ein Ergebnis dieser Mischung sind. Dadurch, daß die Frequenz des Ausgangssignals des Frequenzteilers 805 um Faktor N geringer als die Frequenz der Ansteuersignale 5191 und 5193 ist, kann nun durch eine Ansteuerung des Lokaloszillators 519 sowie durch eine Wahl eines Teilerverhältnisses N die Oszillationsfrequenz des Lokaloszillators 519 derart eingestellt werden, daß das Empfangssignal auf die erste Zwischenfrequenz umgesetzt wird.

Die in Fig. 8 dargestellte Struktur ist insbesondere dann vorteilhaft, wenn die Empfangssignale mit Hilfe eines Frequency-Hopping-Schemas codiert sind. Bei einem Frequency-Hopping-Schema wird eine Trägerfrequenz des übertragenen Signals in aufeinanderfolgenden Zeitschlitzen verändert, so daß ein Bandspreizungseffekt entsteht, der zu einer Verbesserung des Signal zu Rauschverhältnisses in einem Empfänger beiträgt. Da ein Frequenzplan, nachdem die Trägerfrequenz des Übertragungssignals verändert wird, bekannt ist, kann vorzugsweise empfangsseitig diesem Frequenzplan gefolgt werden, so daß das Empfangssignal unabhängig von einer momentanen Trägerfrequenz auf die beispielsweise fest vorgegebene erste Zwischenfrequenz umgesetzt wird. Die Kalibrierung der erfindungsgemäßen Frequenzauswahleinrichtung kann hierbei während der leeren Zeitschlitze erfolgen, da während der leeren Zeitschlitze keine Informationsübertragung stattfindet. Mit Hilfe einer in Fig. 8 nicht eingezeichneten Einrichtung, die beispielsweise die Phasendetektionseinrichtung 405 aus Fig. 7 sein kann, kann die Oszillationsfrequenz des Oszillators 519 nachgeführt werden, wenn beispielsweise eine Frequenz oder eine Phase der Ausgangssignale 809 und 811 erfaßt wird und die Oszillationsfrequenz des Oszillators 519 auf der Basis dieser Erfassung nachgeführt wird, so daß am Ende des leeren Zeitschlitzes die zu einer Umsetzung des Empfangssignals auf die erste Zwischenfrequenz notwendige Oszillationsfrequenz des Lokaloszillators 519 eingestellt wird.

Ein weiterer Vorteil der erfindungsgemäßen Empfängerstruktur ist die digitale Frequenzsynthetisierung. Durch eine digitale Frequenzmessung, die z. B. mit dem bereits erwähnten CORDIC-Algorithmus realisiert werden kann, ist es möglich, die Frequenz einerseits digital oder auch analog zu regeln. Für eine Multistandardstruktur stellt eine Frequenzgenerierung ein Problem dar, da wie bereits erwähnt, aufgrund der notwendigen Breitbandigkeit von beispielsweise in eingesetzten Lokaloszillatoren eine genaue Einstellung einer Oszillationsfrequenz problematisch ist. Diese Schwierigkeit kann mit der erfindungsgemäßen halbdigitalen Struktur weitgehend gelöst werden. Möchte man beispielsweise die Frequenz digital regeln, so ist nur ein geringer Bereich einstellbar. Für beispielsweise einen 200 kHz GSM-Kanal ist dies unter Umständen realisierbar und stellt eine gute Alternative dar.

Erfindungsgemäß ist ferner eine Rückkopplung zum analogen Teil vorgesehen. Das rückgekoppelte analoge Signal kann beispielsweise einen spannungsgesteuerten Oszillator (VCOM VCO = voltage controlled oscillator) ansprechen. Diese VCO kann in der MOS-Technologie nur mit einer größeren Bauteiletoleranz hergestellt werden. Daraus resultiert eine Frequenzungenauigkeit von etwa 20%. Um nun eine hochgenaue Frequenz einstellen zu können, muß das Gesamtsystem vor Inbetriebnahme einmalig kalibriert werden, was mit Hilfe der in Fig. 8 dargestellten Frequenzauswahleinrichtung durchgeführt werden kann. Die gemessenen Werte werden anschließend in einem Speicher abgelegt und stehen dann zur Verfügung. Nach dieser ersten Kalibrierung können weitere Kalibriermaßnahmen notwendig sein, um den Empfänger beispielsweise an veränderliche Bedingungen (Temperaturdrift, Alterung etc.) anzugleichen. Dies ist mit einer Messung der Frequenz bei definiert angelegten Testsignalen, welche von der Schaltung selbst erzeugt werden, wie es in Fig. 8 dargestellt ist (z.B. Steuersignal 801) möglich. Eine Abtastung der hochfrequenten Signals ist mit den Analog-Digital-Wandlern 527 und 529, wie sie in Fig. 7 dargestellt sind, deshalb möglich, weil man eine hohe Unterabtastung realisieren kann. Das entstehende Testsignal, beispielsweise das Ausgangssignal 809 des Mischers 515 ist in einer Amplitude frei einstellbar und kann je nach der gewählten Unterabtastrate einem Aliasing-Rauschen angepaßt werden.

Die in einem TDMA-Betrieb (TDMA; TDMA = time devision multiple access) entstehenden leeren Zeitschlitze werden erfindungsgemäß ausgenutzt, um das von dem Oszillator 519 erzeugte Signal mit einem definierten fraktionalen oder nicht-fraktionalen Faktor N geteilten Signal zu mischen. Die zu messende Frequenz läßt sich nun durch das Teilerverhältnis N so einstellen, daß die Kalibrierung in einem Arbeitsbereich des Empfängers stattfindet. Die beispielsweise durch Übersprechen entstehenden statistischen Gleichspannungsanteile können gemessen werden und von dem Empfangssignal bei beispielsweise einem Burstempfang subtrahiert werden. Diese Anordnung benötigt keinen separaten Quarzoszillator und keine separate Temperaturkompensation. Die Kalibrierfrequenz, also die Häufigkeit einer solchen Messung, erlaubt eine Einstellung der für die Kalibrierung benötigten Energie. Sich rasch ändernde Randbedingungen können im Bursttakt ausgeneriert werden.

Das UMTS-System (UMTS; UMTS = universal mobile telecommunications system) beispielsweise verwendet als Vielfachzugriffsverfahren CDMA (CDMA; CDMA = code devision multiple access). Bei diesem Verfahren stehen keine leeren Zeitschlitze zur Verfügung. Damit ein Multistandardbetrieb gewährleistet werden kann, ist eine kontinuierliche Anpassung, beispielsweise eine Frequenzkorrektur, nötig. Spendiert man beispielsweise für UMTS einen separaten Temperatur-kompensierten Quarzoszillator (TCXO), so ist es durch den frei einstellbaren Teiler für das Testsignal möglich, während des Empfangs von Daten eine Frequenzkalibrierung auf einer separaten Frequenz, die ungleich der Trägerfrequenz ist, durchzuführen. Dieses definiert gewählte Signal kann in der Amplitude stark gedämpft werden, damit keine Interferenzen auftreten. In Abhängigkeit davon, wie weit die Empfangs- und die Testfrequenz auseinander liegen, kommt es zu Störungen. Des weiteren würden die Verstärkungscontroller 523 und 525, wie sie in Fig. 7 dargestellt sind, das Empfangssignal blockieren. Die beiden letztgenannten Nachteile können z.B. durch eine Amplitudendämpfung vermieden werden.

Die erfindungsgemäße Vorrichtung zum Abwärtsmischen zeichnet sich dadurch aus, daß sie eine genauere Spiegelfrequenzunterdrückung ermöglicht als dies bei einem Einsatz der nach dem Stand der Technik bekannten Empfängerstrukturen, die beispielsweise die in Fig. 3 dargestellte Form aufweisen, der Fall ist. Um einen Eindruck der Fehlergrößen zu erhalten, ist die Größe IRR (image reject ratio) heranzuziehen. Diese Größe ist ein Maß für die Spiegelfrequenzunterdrückung in dB. Dieses Verhältnis der Spiegelfrequenzunterdrückung erhält man, indem man dem Q-Pfad eine fehlerhafte Amplitude und eine Fehlerphase hinzurechnet beispielsweise die in Fig. 3 dargestellte Weaver-Struktur analytisch berechnet. In der folgenden Schrift: J. Rodell: A 1.9 GHz wide band IF double conversion CMOS receiver for cordless telephone applications wurde dies für die herkömmliche Weaver-Struktur berechnet. Für die hier modifizierte Struktur sind neue Berechnungen nötig. Die resultierende Form des IRR lautet:

$$IRR(dB) = 10 \cdot \log\left[\frac{1 + (1 + \Delta G)^2 + 2 \cdot (1 + \Delta G) \cdot \cos(\Delta\phi)}{1 + (1 + \Delta G)^2 - 2 \cdot (1 + \Delta G) \cdot \cos(\Delta\phi)}\right] .$$

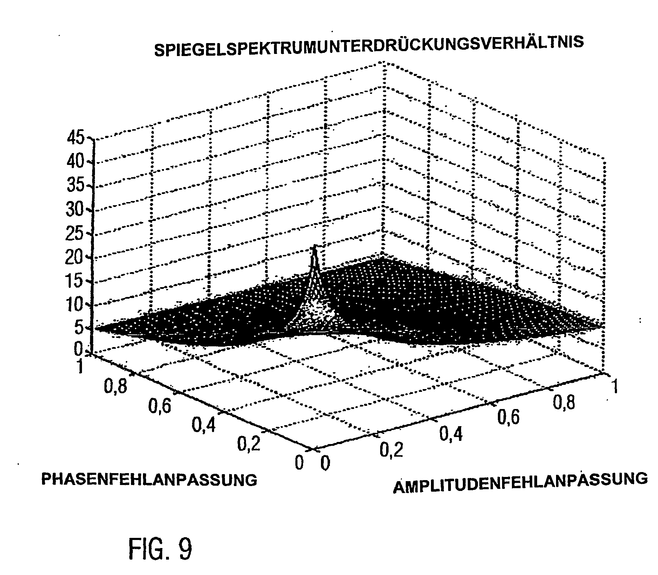

Hierbei bezeichnet $\Delta G$ eine Amplitudenabweichung und $\Delta\phi$ eine Phasenabweichung in Grad. In Fig. 9 ist ein Simulationsergebnis eines Spiegelunterdrückungsverhältnisses bei einer Verwendung von analogen Empfangsstufen dargestellt. Diese Graphik zeigt deutlich, daß eine geringe Phasenabweichung von beispielsweise 0.1 Grad die Spiegelfrequenzunterdrückung auf etwa 37 dB verringert. Dies ist ein in analogen Schaltungen üblicher Wert. Möchte man nun diese Phasenunsicherheit digital kompensieren, so ist eine Auflösung von beispielsweise 3600 Abtastpunkten pro Periode nötig. Da man weiterhin die Möglichkeit hat, sowohl einen I-Pfad als auch einen Q-Pfad gegeneinander zu verschieben, würde man auch mit der Hälfte der Abtastpunkte auskommen. Eine derartige Überabtastung würde unter Umständen die Anforderungen, die an die Analog-Digital-Wandler gestellt sind, übersteigen. Erfindungsgemäß ist es jedoch möglich, keine absoluten Fehler, sondern lediglich differentielle Fehler zu detektieren und zu korrigieren, wodurch eine algorithmische Berechnung auch niederratig durchgeführt werden kann. Die Formel des geometrischen Pythagoras ist ein erster Ansatz.

$$\int_{-\frac{T}{2}}^{+\frac{T}{2}} \cos^2(\omega \cdot t) + \cos^2(\omega \cdot t) dt = 0$$

Digital ist die Integration durch eine Summe zu ersetzen. Berechnet man diese Formel, also Quadrieren der digitalen Wertepaare, anschließendes Addieren und Summieren, so ist der Integralwert nur bei einer perfekten Anpassung gleich 0. Jede positive oder negative Abweichung ist ein Maß für eine Größe dieser Abweichung. Dieses digitale Maß könnte nun wieder analog gewandelt werden, und als ein differentielles Spannungssignal beispielsweise einem Varaktor (spannungsabhängiger Kondensator) steuern. Dieser Varaktor sollte Bestandteil des Phasenschiebers zwischen der I- und der Q-Komponente sein. Voraussetzung für eine derartige Berechnung ist jedoch eine 100%-ige Amplitudenanpassung. Da die Amplitudenberechnung digital einfach zu implementieren ist, arbeitet diese Anpassung konvergent.

Die erfindungsgemäße Struktur erlaubt es, die von einem Heterodyn-Empfänger bekannten Nachteile wie beispielsweise eine Frequenzplanungsproblematik, weitgehend zu eliminieren. Die erfindungsgemäße Vorrichtung erlaubt es ferner, die aufwendigen Heterodyn-Empfänger flexibel genug für einen Multistandardbetrieb zu gestalten. Durch eine Analog/Digital-Partitionierung sind ferner wesentliche Empfängerelemente, wie beispielsweise die Kanalselektionsfilter, Mischer, etc. nun digital ausführbar. Dies hat den entscheidenden Vorzug einer parametergesteuerten Rekonfiguration der Elemente. Die erfindungsgemäße Korrektur der inperfekten analogen Eigenschaften eines jeden Empfängers bietet einen hohen Grad an Genauigkeit, somit gibt es speziell in dem Bereich der Spiegelfrequenzunterdrückung eine höhere Dämpfung, als dies mit Strukturen nach dem Stand der Technik der Fall ist. Neben einer Spiegelfrequenzunterdrückung können auch Amplituden und Phasendifferenzen mit der erfindungsgemäßen Struktur eliminiert werden, wie ein I/Q-Mismatch, welches die Demodulation erschwert bzw. verschlechtert.

Abhängig von den Gegebenheiten kann das erfindungsgemäße Verfahren zum Abwärtsmischen eines Eingangssignals in ein Ausgangssignal in Hardware oder in Software implementiert werden. Die Implementation kann auf einem digitalen Speichermedium, insbesondere einer Diskette oder CD mit elektronisch auslesbaren Steuersignalen erfolgen, die so mit einem programmierbaren Computersystem zusammenwirken können, daß das entsprechende Verfahren ausgeführt wird. Allgemein besteht die Erfindung somit auch in einem Computer-Programm-Produkt mit auf einem maschinenlesbaren Träger gespeicherten Programmcode zur Durchführung des erfindungsgemäßen Verfahrens, wenn das Computer-Programm-Produkt auf einem Rechner abläuft. In anderen Worten ausgedruckt kann die Erfindung somit als ein Computer-Programm mit einem Programmcode zur Durchführung des Verfahrens realisiert werden, wenn das Computer-Programm auf einem Computer abläuft.

**Patentansprüche**

1.    Vorrichtung zum Abwärtsmischen eines Eingangssignals in ein Ausgangssignal, mit folgenden Merkmalen:

einer Einrichtung (401) zum Erzeugen eines ersten Empfangssignals (4011) und eines zweiten Empfangssignals (4013) auf einer ersten Zwischenfrequenz, wobei die Einrichtung (401) zum Erzeugen ausgebildet ist, um das erste Empfangssignal (4011) und das zweite Empfangssignal (4013) mit einer vorbestimmten ersten Phasenbeziehung zueinander zu erzeugen;

einer Wandlereinrichtung (403) zum Analog-Digital-Wandeln des ersten Empfangssignals (4011) auf der ersten Zwischenfrequenz, um eine digitale Darstellung (4031) des ersten Empfangssignals (4011) zu erhalten, und zum Analog-Digital-Wandeln des zweiten Empfangssignals (4013), um eine digitale Darstellung (4033) des zweiten Empfangssignals (4013) zu erhalten;

einer Phasendetektionseinrichtung (405) zum Erfassen eines Phasenunterschieds zwischen der digitalen Darstellung (4031) des ersten Empfangssignals (4011) und der digitalen Darstellung (4033) des zweiten Empfangssignals;

einer ersten Mischereinrichtung (407) zum Umsetzen der digitalen Darstellung (4031) des ersten Empfangssignals (4011) auf eine zweite Zwischenfrequenz;

einer zweiten Mischereinrichtung (409) zum Umsetzen der digitalen Darstellung (4033) des zweiten Empfangssignals (4013) auf die zweite Zwischenfrequenz;

einer Mischeransteuereinrichtung (411) zum Ansteuern der ersten Mischereinrichtung (407) mit einem ersten Ansteuersignal (4111), das eine erste Frequenz aufweist, und zum Ansteuern der zweiten Mischereinrichtung (409) mit einem zweiten Ansteuersignal (4113), das die erste Frequenz aufweist, wobei das erste und das zweite Ansteuersignal (4111 und 4113) eine vorbestimmte erste Phasendifferenz aufweisen;

einer Summationseinrichtung (413) zum Summieren der Ausgangssignale der ersten Mischereinrichtung (407) und der zweiten Mischereinrichtung (409);

wobei die Phasendetektionseinrichtung (405) ausgebildet ist, um die Einrichtung (401) zum Erzeugen anzusteuern, um eine Fehlanpassung zwischen der digitalen Darstellung (4031) des ersten Empfangssignals (4011) und der digitalen Darstellung (4033) des zweiten Empfangssignals zu reduzieren, und um die Mischeransteuereinrichtung (405) anzusteuern, um eine verbleibende Fehlanpassung zwischen der digitalen Darstellung (4031) des ersten Empfangssignals (4011) und der digitalen Darstellung (4033) des zweiten Empfangssignals digital zu kompensieren, so daß die Ausgangssignale der ersten Mischereinrichtung (407) und der zweiten Mischereinrichtung (409) in einer vorbestimmten Phasenbeziehung zueinander sind, so daß eine Spiegelfrequenzunterdrückung stattfindet.

2.    Vorrichtung gemäß Anspruch 1, bei der die Phasendetektionseinrichtung (405) ferner ausgebildet ist, um jeweils eine Amplitude und eine Frequenz der digitalen Darstellung des ersten Empfangssignals (4011) und/oder des zweiten Empfangssignals (4013) zu erfassen.

3.    Vorrichtung gemäß Anspruch 2, bei der die Phasendetektionseinrichtung (405) einen Digital-Analog-Wandler (531) zum Erzeugen eines analogen Ansteuersignals aus den von der Phasendetektionseinrichtung (405) jeweils erfaßten Größen zu Ansteuern der Einrichtung (401) zum Erzeugen aufweist.

4.    Vorrichtung gemäß einem der Ansprüche 1-3, bei der die Einrichtung (401) zum Erzeugen des ersten Empfangssignals (4011) und des zweiten Empfangssignals (4013) folgende Merkmale aufweist:

eine Verzweigungseinrichtung zum Aufteilen des Empfangssignals in ein erstes und ein zweites Teilempfangssignal;

eine dritte Mischereinrichtung (515) zum Liefern des ersten Empfangssignals (4011) durch Umsetzen des ersten Teilempfangssignals auf die erste Zwischenfrequenz;

eine vierte Mischereinrichtung (517) zum Liefern des zweiten Empfangssignals (4013) durch Umsetzen des zweiten Teilempfangssignals auf die erste Zwischenfrequenz;

eine weitere Mischeransteuerungseinrichtung zum Ansteuern der dritten Mischereinrichtung (515) mit einem dritten Ansteuersignal (5191), das eine zweite Frequenz aufweist, und zum Ansteuern der vierten Mischereinrichtung (517) mit einem vierten Ansteuersignal, das die zweite Frequenz aufweist, wobei das dritte und das vierte Ansteuersignal eine vorbestimmte zweite Phasendifferenz aufweisen.

5. Vorrichtung gemäß Anspruch 4, wobei die weitere Mischeransteuereinrichtung einen Lokaloszillator (519) zum Erzeugen des dritten Ansteuersignals (5191) und des vierten Ansteuersignals (5193) und einen steuerbaren Phasenschieber zum Einstellen der zweiten Phasendifferenz zwischen dem dritten und dem vierten Ansteuersignal aufweist; wobei der Phasenschieber von der Phasendetektionseinrichtung (405) angesteuert wird.

6. Vorrichtung gemäß Anspruch 5, bei der der Lokaloszillator (519) von der Phasendetektionseinrichtung (405) steuerbar ist, um das dritte Ansteuersignal (5191) und um das vierte Ansteuersignal (5193) mit der zweiten Frequenz zu erzeugen.

7. Vorrichtung gemäß Anspruch 6, bei der die Einrichtung (401) zum Erzeugen ferner eine Frequenzauswahleinrichtung aufweist, um die zweite Frequenz in Abhängigkeit von einer Trägerfrequenz, die dem Empfangssignal zugeordnet ist, einzustellen.

8. Vorrichtung gemäß einem der Ansprüche 1-7, bei der die Wandlereinrichtung (403) einen ersten Analog-Digital-Wandler (527) zum Erhalten der digitalen Darstellung des ersten Empfangssignals (4011) und einen zweiten Analog-Digital-Wandler (529) zum Erhalten der digitalen Darstellung des zweiten Empfangssignals (413) aufweist.

9. Vorrichtung gemäß Anspruch 1, bei der die Wandlereinrichtung (403) ferner einen ersten steuerbaren Verstärkungscontroller (523) zum Einstellen einer Amplitude des ersten Empfangssignals (4011) und einen zweiten steuerbaren Verstärkungscontroller (529) zum Einstellen einer Amplitude des zweiten Empfangssignals (4013) aufweist, um den ersten und den zweiten Analog-Digital-Wandler anzusteuern; wobei der erste und der zweite steuerbare Verstärkungscontroller von der Phasendetektionseinrichtung (405) auf der Basis,der erfaßten jeweiligen Amplitude der digitalen Darstellung des ersten Empfangssignals (4011) und/oder des zweiten Empfangssignals (4013) angesteuert wird.

10. Vorrichtung gemäß einem der Ansprüche 1-9, bei der das von der Mischeransteuereinrichtung (411) gelieferte erste Ansteuersignal (5191) und/oder das zweite Ansteuersignal (5193) jeweils digital ist.

11. Vorrichtung gemäß Anspruch 10, bei der die erste Phasendifferenz zwischen dem ersten und dem zweiten Ansteuersignal digital einstellbar ist.

12. Vorrichtung gemäß einem der Ansprüche 10-11, bei der die erste Mischereinrichtung (407) und die zweite Mischereinrichtung (409) jeweils einen digitalen Multiplizierer zum digitalen Umsetzen der digitalen Darstellung (4031) des ersten Empfangssignals (4011) und der digitalen Darstellung (4033) des zweiten Empfangssignals (4013) auf die zweite Zwischenfrequenz aufweisen.

13. Vorrichtung gemäß einem der Ansprüche 10-12, wobei die Mischeransteuereinrichtung (411) zum Einstellen der ersten Phasendifferenz zwischen den ersten Ansteuersignal (4111) und dem zweiten Ansteuersignal (4113) steuerbar ist.

14. Vorrichtung gemäß einem der Ansprüche 10-13, bei der die Mischeransteuereinrichtung (411) ferner ausgebildet ist, um eine Frequenz des ersten und des zweiten Ansteuersignals zu steuern, wobei die Frequenz des ersten und des zweiten Ansteuersignals digital einstellbar ist.

15. Vorrichtung gemäß einem der Ansprüche 1-14, bei der die Summationseinrichtung digital ist.

16. Verfahren zum Abwärtsmischen eines Eingangssignals in ein Ausgangssignal mit folgenden Schritten:

Erzeugen eines ersten Empfangssignals (4011) und eines zweiten Empfangssignals (4013) auf einer ersten Zwischenfrequenz;

Erzeugen einer vorbestimmten ersten Phasenbeziehung zwischen dem ersten Empfangssignal (4011) und dem zweiten Empfangssignal (4013);

Analog-Digital-Wandeln des ersten Empfangssignals (4011) auf der ersten Zwischenfrequenz, um eine digitale Darstellung (4031) des ersten Empfangssignals (4011) zu erhalten und Analog-Digital-Wandeln des zweiten Empfangssignals (4013) auf der ersten Zwischenfrequenz, um eine digitale Darstellung (4033) des zweiten Empfangssignals (4013) zu erhalten;

Erfassen eines Phasenunterschieds zwischen der digitalen Darstellung (4031) des ersten Empfangssignals (4011) und der digitalen Darstellung (4033) des zweiten Empfangssignals (4013);

Ändern einer Phasenbeziehung zwischen dem ersten Empfangssignal (4011) und dem zweiten Empfangssignal (4013), um eine Fehlanpassung zwischen der digitalen Darstellung (4031) des ersten Empfangssignals (4011) und der digitalen Darstellung (4033) des zweiten Empfangssignals (4013) zu reduzieren;

Erzeugen eines ersten Ansteuersignals (4111) und eines zweiten Ansteuersignals (4113) zum Umsetzen der digitalen Darstellung (4031) des ersten Empfangssignals (4011) und der digitalen Darstellung (4033) des zweiten Empfangssignals (4013) auf eine zweite Zwischenfrequenz;

Erzeugen einer vorbestimmten Phasendifferenz zwischen dem ersten und dem zweiten Ansteuersignal, um eine verbleibende Fehlanpassung zwischen der digitalen Darstellung (4031) des ersten Empfangssignals (4011) und der digitalen Darstellung (4033) des zweiten Empfangssignals bei der Umsetzung auf die zweite Zwischenfrequenz digital zu kompensieren;

Umsetzen der digitalen Darstellung (4031) des ersten Empfangssignals (4011) und der digitalen Darstellung (4033) des zweiten Empfangssignals (4013) auf die zweite Zwischenfrequenz, so daß die umgesetzte digitale Darstellung (4031) des ersten Empfangssignals (4011) und die umgesetzte digitale Darstellung (4033) des zweiten Empfangssignals (4013) in einer vorbestimmten Phasenbeziehung zueinander sind;

Summieren der umgesetzten digitalen Darstellung des ersten und des zweiten Empfangssignals, so daß aufgrund der vorbestimmten Phasenbeziehung eine Spiegelfrequenzunterdrückung stattfindet.

**17.** Computer-Programm mit einem Programmcode zur Durchführung des Verfahrens nach Anspruch 16, wenn das Computer-Programm auf einem Computer abläuft.

**Claims**

**1.** A device for downward mixing an input signal into an output signal, comprising:

means (401) for generating a first receive signal (4011) and a second receive signal (4013) on a first intermediate frequency, wherein means (401) for generating is implemented in order to generate the first receive signal (4011) and the second receive signal (4013) with a predetermined first phase relation to each other;

a converter means (403) for analog/digital converting the first receive signal (4011) on the first intermediate frequency in order to obtain a digital representation (4031) of the first receive signal (4011) and for analog/digital converting the second receive signal (4013) in order to obtain a digital representation (4033) of the second receive signal (4013);

a phase detection means (405) for detecting a phase difference between the digital representation (4031) of the first receive signal (4011) and the digital representation (4033) of the second receive signal;

a first mixer means (407) for converting the digital representation (4031) of the first receive signal (4011) onto a second intermediate frequency;

a second mixer means (409) for converting the digital representation (4033) of the second receive signal (4013) onto the second intermediate frequency;

a mixer control means (411) for controlling the first mixer means (407) with a first control signal (4111) comprising a first frequency and for controlling the second mixer means (409) with a second control signal (4113) comprising the first frequency, wherein the first and the second control signal (4111 and 4113) comprise a predetermined first phase difference;

a summation means (413) for summing the output signals of the first mixer means (407) and the second mixer means (409);

wherein the phase detection means (405) is implemented in order to control means (401) for generating in order to reduce a mismatch between the digital representation (4031) of the first receive signal (4011) and the digital representation (4033) of the second receive signal and to control mixer control means (405) in order to digitally compensate a remaining mismatch between the digital representation (4031) of the first receive signal (4011) and the digital representation (4033) of the second receive signal so that the output signals of the first mixer means (407) and the second mixer means (409) are in a predetermined phase relation to each other, so that an image frequency rejection occurs.

**2.** The device according to claim 1, wherein the phase detection means (405) is further implemented in order to respectively detect an amplitude and a frequency of the digital representation of the first receive signal (4011) and/or the second receive signal (4013).

**3.** The device according to claim 2, wherein the phase detection means (405) comprises a digital/analog converter (531) for generating an analog control signal from the quantities respectively detected by the phase detection means (405) for controlling means (401) for generating.

**4.** The device according to one of claims 1-3, wherein means (401) for generating the first receive signal (4011) and the second receive signal (4013) further comprises:

a branching means for dividing the receive signal into a first and a second partial receive signal;
a third mixer means (515) for providing the first receive signal (4011) by converting the first partial receive signal onto the first intermediate frequency;
a fourth mixer means (517) for providing the second receive signal (4013) by converting the second partial receive signal onto the first intermediate frequency;
a further mixer control means for controlling the third mixer means (515) using a third control signal (5191) comprising a second frequency, and for controlling the fourth mixer means (517) with a fourth control signal comprising the second frequency, wherein the third and the fourth control signals comprise a predetermined second phase difference.

**5.** The device according to claim 4, wherein the further mixer control means comprises a local oscillator (519) for generating the third control signal (5191) and the fourth control signal (5193) and a controllable phase shifter for setting the second phase difference between the third and the fourth control signal;
wherein the phase shifter is controlled by the phase detection means (405).

**6.** The device according to claim 5, wherein the local oscillator (519) is controllable by the phase detection means (405) in order to generate the third control signal (5191) and the fourth control signal (5193) using the second frequency.

**7.** The device according to claim 6, wherein means (401) for generating further comprises a frequency selection means in order to set the second frequency depending on a carrier frequency associated with the receive signal.

**8.** The device according to one of claims 1-7, wherein the converter means (403) comprises a first analog/digital converter (527) for obtaining the digital representation of the first receive signal (4011) and a second analog/digital converter (529) for obtaining the digital representation of the second receive signal (413).

**9.** The device according to claim 1, wherein the converter means (403) further comprises a first controllable amplification controller (523) for setting an amplitude of the first receive signal (4011), and a second controllable amplification controller (529) for setting an amplitude of the second receive signal (4013) in order to control the first and the second analog/digital converter;
wherein the first and the second controllable amplification controllers are controlled by the phase detection means (405) on the basis of the detected respective amplitude of the digital representation of the first receive signal (4011) and/or the second receive signal (4013).

**10.** The device according to one of claims 1-9, wherein the first control signal (5191) and/or the second control signal (5193) provided by the mixer control means (411) are respectively digital.

**11.** The device according to claim 10, wherein the first phase difference between the first and the second control signal is digitally settable.

**12.** The device according to one of claims 10-11, wherein the first mixer means (407) and the second mixer means (409) respectively comprise a digital multiplier for digitally converting the digital representation (4031) of the first receive signal (4011) and the digital representation (4033) of the second receive signal (4013) onto the second intermediate frequency.

**13.** The device according to one of claims 10-12, wherein the mixer control means (411) is controllable for setting the first phase difference between the first control signal (4111) and the second control signal (4113).

**14.** The device according to one of claims 10-13, wherein the mixer control means (411) is further implemented in order to control a frequency of the first and the second control signal, wherein the frequency of the first and the second control signal is digitally settable.

**15.** The device according to one of claims 1-14, wherein the summation means is digital.

**16.** A method for downward mixing an input signal into an output signal, comprising:

generating a first receive signal (4011) and a second receive signal (4013) on a first intermediate frequency;
generating a predetermined first phase relation between the first receive signal (4011) and the second receive signal (4013);
analog/digital converting the first receive signal (4011) on the first intermediate frequency in order to obtain a digital representation (4031) of the first receive signal (4011), and analog/digital converting the second receive signal (4013) on the first intermediate frequency in order to obtain a digital representation (4033) of the second receive signal (4013);
detecting a phase difference between the digital representation (4031) of the first receive signal (4011) and the digital representation (4033) of the second receive signal (4013);
changing a phase relation between the first receive signal (4011) and the second receive signal (4013) in order to reduce a mismatch between the digital representation (4031) of the first receive signal (4011) and the digital representation (4033) of the second receive signal (4013);
generating a first control signal (4111) and a second control signal (4113) for converting the digital representation (4031) of the first receive signal (4011) and the digital representation (4033) of the second receive signal (4013) to a second intermediate frequency;
generating a predetermined phase difference between the first and the second control signal in order to digitally compensate for a remaining mismatch between the digital representation (4031) of the first receive signal (4011) and the digital representation (4033) of the second receive signal (4013) in the conversion to the second intermediate frequency;
converting the digital representation (4031) of the first receive signal (4011) and the digital representation (4033) of the second receive signal (4013) to the second intermediate frequency, so that the converted digital representation (4031) of the first receive signal (4011) and the converted digital representation (4033) of the second receive signal (4013) are in a predetermined phase relation to each other;
summing the converted digital representation of the first and the second receive signal so that an image frequency rejection occurs based on the predetermined phase relation.

**17.** A computer program having a program code for performing the method of claim 16 when the computer program runs on a computer.

**Revendications**

**1.** Dispositif permettant le mélange en abaissement d'un signal d'entrée, pour obtenir un signal de sortie, aux caractéristiques suivantes :

un dispositif (401) destiné à générer un premier signal de réception (4011) et un deuxième signal de réception (4013) à une première fréquence intermédiaire, le dispositif de génération (401) étant réalisé de manière à générer le premier signal de réception (4011) et le deuxième signal de génération (4013) avec un premier rapport de phase prédéterminé ;
un dispositif de conversion (403) destiné à la conversion analogique-numérique du premier signal de réception (4011) à la première fréquence intermédiaire, pour obtenir une représentation numérique (4031) du premier signal de réception (4011), et à la conversion analogique-numérique du deuxième signal de réception (4013), pour obtenir une représentation numérique (4033) du deuxième signal de réception (4013) ;
un dispositif de détection de phase (405) destiné à capter une différence de phase entre la représentation numérique (4031) du premier signal de réception (4011) et la représentation numérique (4033) du deuxième signal de réception ;

un premier dispositif mélangeur (407) destiné à convertir la représentation numérique (4031) du premier signal de réception (4011) à une deuxième fréquence intermédiaire ;

un deuxième dispositif mélangeur (409) destiné à convertir la représentation numérique (4033) du deuxième signal de réception (4013) à la deuxième fréquence intermédiaire ;

un dispositif d'activation de mélangeur (411) destiné à activer le premier dispositif mélangeur (407) par un premier signal d'activation (4111) présentant une première fréquence, et à activer le deuxième dispositif mélangeur (409) par un deuxième signal d'activation (4113) présentant la première fréquence, le premier et le deuxième signal d'activation (4111 et 4113) présentant une première différence de phase prédéterminée ;

un dispositif de sommation (413) destiné à additionner les signaux de sortie du premier dispositif mélangeur (407) et du deuxième dispositif mélangeur (409) ;

le dispositif de détection de phase (405) étant réalisé de manière à activer le dispositif de génération (401) de manière à réduire un défaut d'adaptation entre la représentation numérique (4031) du premier signal de réception (4011) et la représentation numérique (4033) du deuxième signal de réception et à activer le dispositif d'activation de mélangeur (405) de manière à compenser numériquement un défaut d'adaptation restant entre la représentation numérique (4031) du premier signal de réception (4011) et la représentation numérique (4033) du deuxième signal de réception, de sorte que les signaux de sortie du premier dispositif mélangeur (407) et du deuxième dispositif mélangeur (409) présentent un rapport de phase prédéterminé entre eux, de sorte qu'ait lieu une suppression de fréquence miroir.

2.  Dispositif selon la revendication 1, dans lequel le dispositif de détection de phase (405) est, par ailleurs, réalisé de manière à capter chaque fois une amplitude et une fréquence de la représentation numérique du premier signal de réception (4011) et/ou du deuxième signal de réception (4013).

3.  Dispositif selon la revendication 2, dans lequel le dispositif de détection de phase (405) présente un convertisseur numérique-analogique (531) pour générer un signal d'activation analogique à partir de chacune des grandeurs captées par le dispositif de détection de phase (405) pour l'activation du dispositif de génération (401).

4.  Dispositif selon l'une des revendications 1 à 3, dans lequel le dispositif (401) de génération du premier signal de réception (4011) et du deuxième signal de réception (4013) présente les caractéristiques suivantes :

un dispositif de division destiné à diviser le signal de réception en un premier et un deuxième signal de réception partiel ;

un troisième dispositif mélangeur (515) destiné à fournir le premier signal de réception (4011) en convertissant le premiers signal de réception partiel à la première fréquence intermédiaire ;

un quatrième dispositif mélangeur (517) destiné à fournir le deuxième signal de réception (4013) par conversion du deuxième signal de réception partiel à la première fréquence intermédiaire ;

un autre dispositif de commande de mélangeur destiné à activer le troisième dispositif mélangeur (515) par un troisième signal d'activation (5191) présentant une deuxième fréquence, et à activer le quatrième dispositif mélangeur (517) par un quatrième signal d'activation présentant la deuxième fréquence, le troisième et le quatrième signal d'activation présentant une deuxième différence de phase prédéterminée.

5.  Dispositif selon la revendication 4, l'autre dispositif de commande de mélangeur présentant un oscillateur local (519) destiné à générer le troisième signal d'activation (5191) et le quatrième signal d'activation (5193) et un déphaseur destiné à régler la deuxième différence de phase entre le troisième et le quatrième signal d'activation;

le déphaseur étant activé par le dispositif de détection de phase (405).

6.  Dispositif selon la revendication 5, dans lequel l'oscillateur local (519) peut être commandé par le dispositif de détection de phase (405), pour générer le troisième signal d'activation (5191) et le quatrième signal d'activation (5193) par la deuxième fréquence.

7.  Dispositif selon la revendication 6, dans lequel le dispositif de génération (401) présente, par ailleurs un dispositif de sélection de fréquence destiné à régler la deuxième fréquence en fonction d'une fréquence de porteuse qui est associée au signal de réception.

8.  Dispositif selon l'une des revendications 1 à 7, dans lequel le dispositif de conversion (403) présente un premier convertisseur analogique-numérique (527) destiné à recevoir la représentation numérique du premier signal de réception (4011) et un deuxième convertisseur analogique-numérique (529) destiné à recevoir la représentation numérique du deuxième signal de réception (413).

9. Dispositif selon la revendication 1, dans lequel le dispositif de conversion (403) présente, par ailleurs, un premier contrôleur d'amplification contrôlable (523) destiné à régler une amplitude du premier signal de réception (4011) et un deuxième contrôleur d'amplification contrôlable (529) destiné à régler une amplitude du deuxième signal de réception (4013), pour activer le premier et le deuxième convertisseur analogique-numérique ;
le premier et le deuxième contrôleur d'amplification contrôlable étant activés par le dispositif de détection de phase (405) sur base de l'amplitude respective captée de la représentation numérique du premier signal de réception (4011) et/ou du deuxième signal de réception (4013).

10. Dispositif selon l'une des revendications 1 à 9, dans lequel le premier signal d'activation (5191) et/ou le deuxième signal d'activation (5193) fournis par le dispositif d'activation de mélangeur (411) sont, chacun, numériques.

11. Dispositif selon la revendication 10, dans lequel la première différence de phase entre le premier et le deuxième signal d'activation est réglable numériquement.

12. Dispositif selon l'une des revendications 10 à 11, dans lequel le premier dispositif mélangeur (407) et le deuxième dispositif mélangeur (409) présentent, chacun, un multiplicateur numérique destiné à la conversion numérique de la représentation numérique (4031) du premier signal de réception (4011) et de la représentation numérique (4033) du deuxième signal de réception (4013) à la deuxième fréquence intermédiaire.

13. Dispositif selon l'une des revendications 10 à 12, dans lequel le dispositif d'activation de mélangeur (411) destiné à régler la première différence de phase entre le premier signal d'activation (4111) et le deuxième signal d'activation (4113) est réglable.

14. Dispositif selon l'une des revendications 10 à 13, dans lequel le dispositif d'activation de mélangeur (411) est, par ailleurs, réalisé de manière à régler une première fréquence du premier et du deuxième signal d'activation, la fréquence du premier et du deuxième signal d'activation étant réglable numériquement.

15. Dispositif selon l'une des revendications 1 à 14, dans lequel le dispositif de sommation est numérique.

16. Procédé permettant le mélange en abaissement d'un signal d'entrée, pour obtenir un signal de sortie, aux étapes suivantes :

   générer un premier signal de réception (4011) et un deuxième signal de réception (4013) à une première fréquence intermédiaire ;
   générer un premier rapport de phase prédéterminé entre le premier signal de réception (4011) et le deuxième signal de réception (4013) ;
   convertir de manière numérique-analogique le premier signal de réception (4011) à la première fréquence intermédiaire, pour obtenir une représentation numérique (4031) du premier signal de réception (4011) et convertir de manière analogique-numérique le deuxième signal de réception (4013) à la première fréquence intermédiaire, pour obtenir une représentation numérique (4033) du deuxième signal de réception (4013) ;
   capter une différence de phase entre la représentation numérique (4031) du premier signal de réception (4011) et la représentation numérique (4033) du deuxième signal de réception (4013) ;
   modifier un rapport de phase entre le premier signal de réception (4011) et le deuxième signal de réception (4013), pour réduire un défaut d'adaptation entre la représentation numérique (4031) du premier signal de réception (4011) et la représentation numérique (4033) du deuxième signal de réception (4013) ;
   générer un premier signal d'activation (4111) et un deuxième signal d'activation (4113) pour convertir la représentation numérique (4031) du premier signal de réception (4011) et la représentation numérique (4033) du deuxième signal de réception (4013) à la deuxième fréquence intermédiaire ;
   générer une différence de phase prédéterminée entre le premier et le deuxième signal d'activation, pour compenser numériquement un défaut d'adaptation restant entre la représentation numérique (4031) du premier signal de réception (4011) et la représentation numérique (4033) du deuxième signal de réception lors de la conversion à la deuxième fréquence intermédiaire;
   convertir la représentation numérique (4031) du premier signal de réception (4011) et la représentation numérique (4033) du deuxième signal de réception (4013) à la deuxième fréquence intermédiaire, de sorte que la représentation numérique convertie (4031) du premier signal de réception (4011) et la représentation numérique convertie (4033) du deuxième signal de réception (4013) présentent un rapport de phase prédéterminée entre eux ;
additionner la représentation numérique convertie du premier et du deuxième signal de réception, de sorte qu'ait lieu, par suite du rapport de phase prédéterminé, une suppression de fréquence miroir.

**17.** Programme d'ordinateur avec un code de programme pour exécuter le procédé selon la revendication 16 lorsque le programme d'ordinateur se déroule sur un ordinateur.

FIG. 1

EP 1 586 167 B1

FIG. 2

FIG. 3

EP 1 586 167 B1

FIG. 4

EINGANGS-SIGNAL

4053

4011

4031

407
1. MISCHER-EINRICHTUNG

411

EINRICHTUNG ZUM ERZEUGEN EINES 1. EMPFANGSSIGNALS UND EINES 2. EMPFANGS-SIGNALS AUF EINE 1. ZWISCHENFREQUENZ

WANDLER-EINRICHTUNG

PHASEN-DETEKTIONS-EINRICHTUNG

4051

MISCHERANSTEUER-EINRICHTUNG

4111

Σ

AUSGANGS-SIGNAL

413

4013

4033

405

4113

2. MISCHER-EINRICHTUNG

401

403

409

EP 1 586 167 B1

FIG. 5

FIG. 6

FIG. 7

FIG. 8

SPIEGELSPEKTRUMUNTERDRÜCKUNGSVERHÄLTNIS

PHASENFEHLANPASSUNG

AMPLITUDENFEHLANPASSUNG

FIG. 9